# EUROPEAN PATENT APPLICATION

(11) **EP 4 839 060 A2**
(43) Date of publication of application: **11.11.2026**
(21) Application number: 26208004.7
(22) Date of filing: 20.03.2025
(51) Int. Cl.: H10F 77/20

(54) **SOLAR CELL, CELL STACKING STRUCTURE, AND PHOTOVOLTAIC ASSEMBLY**

(30) Priority: 29.03.2024 CN 202420644202 U; 29.03.2024 CN 202420645462 U; 29.03.2024 CN 202420644811 U; 29.03.2024 CN 202420648655 U; 29.03.2024 CN 202420646356 U; 29.03.2024 CN 202420644707 U; 29.03.2024 CN 202420643093 U; 29.03.2024 CN 202410383010; 29.05.2024 CN 202421203803 U; 08.02.2025 CN 202520208673 U; 08.02.2025 CN 202520201131 U; 21.02.2025 CN 202510198949; 21.02.2025 CN 202520291723 U; 25.02.2025 CN 202510215009; 26.02.2025 CN 202510221271
(62) Document number(s) of the earlier application(s) in accordance with Art. 76 EPC: 25744663.3 / 4 651 679
(71) Applicant: LONGi Green Energy Technology Co., Ltd., Xi'an, Shaanxi 710100 (CN)
(72) Inventor: CHEN, Cheng, 710100 Xi' an, Shaanxi (CN); ZHANG, Gang, 710100 Xi' an, Shaanxi (CN); GUO, Menglong, 710100 Xi' an, Shaanxi (CN); TONG, Hongbo, 710100 Xi' an, Shaanxi (CN); YU, Long, 710100 Xi' an, Shaanxi (CN); DENG, Shengjie, 710100 Xi' an, Shaanxi (CN); JIN, Yupeng, Xi' an, Shaanxi, 710100 (CN)
(74) Representative: Pfenning, Meinig & Partner mbB

(57) **Abstract**

The present application discloses a solar cell, a solar cell stack structure, and a photovoltaic module. the solar cell includes: a solar cell body, where the solar cell body has a light receiving surface and a back surface, the back surface is provided with an electrode, and the light receiving surface and/or the back surface is provided with an isolation member. In this way, during stacking of solar cells, the solar cells are isolated and protected, to prevent a solar cell from being scratched by an electrode on an adjacent solar cell.

## Description

### CROSS-REFERENCE TO RELATED APPLICATIONS

The present application claims priority to Chinese Patent Application No. 202421203803.2, filed with the China National Intellectual Property Administration on May 29, 2024 and entitled "SOLAR CELL AND PHOTOVOLTAIC MODULE", priority to Chinese Patent Application No. 202420644202.9, filed with the China National Intellectual Property Administration on March 29, 2024 and entitled "SOLAR CELL AND PHOTOVOLTAIC MODULE", priority to Chinese Patent Application No. 202420648655.9, filed with the China National Intellectual Property Administration on March 29, 2024 and entitled "SOLAR CELL AND PHOTOVOLTAIC MODULE", priority to Chinese Patent Application No. 202420644811.4, filed with the China National Intellectual Property Administration on March 29, 2024 and entitled "SOLAR CELL, SOLAR CELL STACK STRUCTURE, AND SOLAR CELL MODULE", priority to Chinese Patent Application No. 202420643093.9, filed with the China National Intellectual Property Administration on March 29, 2024 and entitled "SOLAR CELL, SOLAR CELL STACK STRUCTURE, AND SOLAR CELL MODULE", priority to Chinese Patent Application No. 202420646356.1, filed with the China National Intellectual Property Administration on March 29, 2024 and entitled "BACK CONTACT SOLAR CELL AND SOLAR CELL MODULE", priority to Chinese Patent Application No. 202420644707.5, filed with the China National Intellectual Property Administration on March 29, 2024 and entitled "BACK CONTACT SOLAR CELL AND SOLAR CELL MODULE", priority to Chinese Patent Application No. 202420645462.8, filed with the China National Intellectual Property Administration on March 29, 2024 and entitled "SOLAR CELL STACK STRUCTURE AND TOOL FOR ACCOMMODATING SOLAR CELL STACK STRUCTURE", priority to Chinese Patent Application No. 202510198949.5, filed with the China National Intellectual Property Administration on February 21, 2025 and entitled "SOLAR CELL AND PHOTOVOLTAIC MODULE", priority to Chinese Patent Application No. 202520201131.X, filed with the China National Intellectual Property Administration on February 08, 2025 and entitled "SOLAR CELL AND PHOTOVOLTAIC MODULE", priority to Chinese Patent Application No. 202520208673.X, filed with the China National Intellectual Property Administration on February 08, 2025 and entitled "SOLAR CELL MODULE", priority to Chinese Patent Application No. 202510215009.2, filed with the China National Intellectual Property Administration on February 25, 2025 and entitled "SOLAR CELL AND PHOTOVOLTAIC MODULE", priority to Chinese Patent Application No. 202510221271.8, filed with the China National Intellectual Property Administration on February 26, 2025 and entitled "SOLAR CELL AND PHOTOVOLTAIC MODULE", priority to Chinese Patent Application No. 202410383010.1, filed with the China National Intellectual Property Administration on March 29, 2024 and entitled "SOLAR CELL AND PHOTOVOLTAIC MODULE", and priority to Chinese Patent Application No. 202520291723.5, filed with the China National Intellectual Property Administration on February 21, 2025 and entitled "SOLAR CELL AND PHOTOVOLTAIC MODULE", each of which is incorporated herein by reference in their entireties.

### TECHNICAL FIELD

The present application relates to the field of photovoltaic technologies, and specifically to a solar cell, a solar cell stack structure, and a photovoltaic module.

### BACKGROUND

In a back contact solar cell, both a positive electrode and a negative electrode are provided on a back surface of the solar cell, to prevent the electrodes from blocking a light receiving surface of the solar cell, thereby improving conversion efficiency of the solar cell.

In a production and manufacturing process of a back contact solar cell, a charging box needs to be used to load and transport solar cells. To avoid scratch between the solar cells, an isolation paper/coated paper may be used to block two adjacent solar cells. However, in a manner of performing isolation by using the isolation paper/coated paper, the isolation paper/coated paper further needs to be drawn and taken out before being laminated, an operation process is relatively complex, use costs of the isolation paper/coated paper are relatively high, and a position of the isolation paper/coated paper is prone to offset. Debris falling off the isolation paper easily adheres to a surface of the solar cell, affecting quality of laminated solar cells. In addition, the number of times of using the isolation paper is limited, discarding of the isolation paper causes relatively large waste in costs, and the isolation paper needs to be recycled and shipped manually, further increasing waste in costs.

### SUMMARY

The present application aims to provide a solar cell, a solar cell stack structure, and a photovoltaic module, to resolve the problem in the related art that surfaces of solar cells are scratched because of relative displacement between the solar cells when the solar cells are stacked and transported.

To resolve the foregoing technical problem, the present application is implemented as follows:

In a first aspect, the present application provides a solar cell, including: a solar cell body, where the solar cell body has a light receiving surface and a back surface, where the back surface is provided with an electrode, and the light receiving surface and/or the back surface is provided with an isolation member.

In an embodiment, the light receiving surface is provided with a plurality of isolation members arranged at intervals, and an extension direction of at least part of the plurality of isolation members is intersected with an extension direction of the electrode.

In an embodiment, a plurality of electrodes sequentially arranged at intervals along a third direction are provided on the back surface, where the isolation member includes a first protective member, at least one of the light receiving surface and the back surface is provided with a plurality of first protective members that are arranged at intervals, and a maximum dimension of an orthographic projection of each of the plurality of first protective members on the back surface along the third direction is greater than a distance between two adjacent electrodes.

In an embodiment, the isolation member is a protective adhesive unit; a protective adhesive layer is provided on at least one of the back surface and the light receiving surface of the solar cell, the back surface is provided with a plurality of electrodes, and the protective adhesive layer includes a plurality of protective adhesive units provided at intervals; and a minimum distance between two adjacent protective adhesive units is less than a projection width of the electrode on the surface of the solar cell.

In an embodiment, the isolation member includes a plurality of first isolation protrusions and a plurality of second isolation protrusions; the electrode includes a plurality of grid lines; the plurality of first isolation protrusions are provided on the back surface of the solar cell body, and the first isolation protrusions protrude from the back surface of the solar cell body; the plurality of second isolation protrusions are provided on the light receiving surface of the solar cell body, and the second isolation protrusions protrude from the light receiving surface of the solar cell body; the plurality of grid lines are provided on at least one surface of the solar cell body; in a thickness direction of the solar cell body, a height of at least one of the plurality of first isolation protrusions and the plurality of second isolation protrusions is greater than heights of all of the grid lines; and projections of the plurality of second isolation protrusions on the back surface of the solar cell body do not intersect with the plurality of first isolation protrusions, or the projections of the plurality of second isolation protrusions on the back surface of the solar cell body are partially intersected with the plurality of first isolation protrusions.

In an embodiment, the solar cell is a back contact solar cell; the isolation member includes an insulation adhesive; the electrode includes a grid line, and the insulation adhesive and the grid line is provided on the back surface of the solar cell body; and in a direction away from the solar cell body, a height of the insulation adhesive is greater than a height of the grid line, and a Mohs hardness of an end portion of the insulation adhesive that faces away from the back contact solar cell ranges from 2 to 7.

In an embodiment, the solar cell is a back contact solar cell; the electrode includes a plurality of support grid lines provided on the back surface of the solar cell body; the isolation member includes a plurality of isolation protrusions provided on the light receiving surface of the solar cell body and protruding from the light receiving surface of the solar cell body, and an arrangement direction of the plurality of isolation protrusions is parallel to an extension direction of the support grid line; and at least part of the plurality of support grid lines overlaps with projections of the plurality of isolation protrusions on the back surface of the solar cell body.

In an embodiment, the back surface is a first surface, and the light receiving surface is a second surface; the electrode includes a plurality of fingers provided on the first surface of the solar cell body; a plurality of isolation members are provided on the first surface and/or the second surface of the solar cell body, and an extension direction of the plurality of isolation members is intersected with an extension direction of the fingers; the plurality of isolation members include a plurality of isolation bumps arranged along the extension direction of the isolation member; and a distance between two adjacent isolation bumps of a same isolation member in the extension direction of the isolation member is greater than a distance between two adjacent fingers.

In an embodiment, the light receiving surface includes a fifth region and a plurality of sixth regions; the isolation member comprises a plurality of isolation members provided on the light receiving surface of the solar cell body, and a density of a part of the plurality of isolation members located in the fifth region is greater than a density of a part of the plurality of isolation members located in each of the plurality of sixth regions; and the solar cell further includes a plurality of fingers provided on the back surface of the solar cell body, the plurality of sixth regions are arranged along an extension direction of the plurality of fingers; and an extension direction of each of the plurality of sixth regions is perpendicular to the plurality of fingers.

In an embodiment, one of the light receiving surface and the back surface is a first surface, and the other is a second surface; and the isolation member includes a plurality of isolation bumps provided on at least one of the first surface and the second surface of the solar cell body, the plurality of isolation bumps are arranged in a plurality of rows along a first direction, and each of the plurality of rows of isolation bumps include a plurality of isolation bumps arranged along a second direction, where *l* is a larger one of a distance between two adjacent isolation bumps along the first direction and a distance between two adjacent isolation bumps along the second direction, h is a height of each of the plurality of isolation bumps, and n is an integer obtained by rounding off a ratio of a long side to a short side of the solar cell, and *l*, h, and n satisfy a relation:
$0 < l < \sqrt[4]{15.3 ∗ {10}^{5} {mm}^{3} ∗ hn}$.

In an embodiment, the isolation member includes a plurality of isolation protrusions arranged at intervals, and a refractive index of the isolation protrusion is less than a refractive index of the solar cell body.

In an embodiment, the back surface is a first surface, and the light receiving surface is a second surface; the electrode includes a plurality of fingers provided on the first surface of the solar cell body; and the isolation member includes a plurality of isolation structures provided on at least one of the first surface and the second surface of the solar cell body, and the plurality of isolation structures are arranged along a direction perpendicular to the plurality of fingers, where a distance between two adjacent fingers is greater than a distance between two adjacent isolation structures along the direction perpendicular to the plurality of fingers.

In a second aspect, the present application provides a photovoltaic module, including the solar cell described above.

In a third aspect, the present application provides a solar cell stack structure, where the solar cell stack structure includes a plurality of solar cells arranged in a stacked manner described above.

The additional aspects and advantages of the present application are partially provided in the following description and partially become evident from the following description or understood through the practice of the present application.

### BRIEF DESCRIPTION OF THE DRAWINGS

The foregoing and/or additional aspects and advantages of the present application will be apparent and easily comprehensible from the description of the embodiments with reference to the accompanying drawings.
FIG. 1 is a schematic diagram of a first solar cell according to a first group of embodiments of the present application;
FIG. 2 is a cross-sectional view of a solar cell according to a first group of embodiments of the present application;
FIG. 3 is a schematic diagram of a second solar cell according to a first group of embodiments of the present application;
FIG. 4 is a schematic diagram of a third solar cell according to a first group of embodiments of the present application;
FIG. 5 is a schematic diagram of a fourth solar cell according to a first group of embodiments of the present application;
FIG. 6 is a schematic diagram of a stack manner of solar cells according to a second group of embodiments of the present application;
FIG. 7 is a schematic diagram of a solar cell according to a second group of embodiments of the present application;
FIG. 8 is a schematic cross-sectional structural view of a solar cell according to a third group of embodiments of the present application;
FIG. 9 is a schematic cross-sectional structural view of a solar cell stack structure according to a third group of embodiments of the present application;
FIG. 10 is a schematic diagram of a first solar cell stack structure according to a fourth group of embodiments of the present application;
FIG. 11 is a schematic diagram of a second solar cell stack structure according to a fourth group of embodiments of the present application;
FIG. 12 is a partial schematic structural diagram of a back surface of a back contact solar cell according to a fifth group of embodiments of the present application;
FIG. 13 is a schematic cross-sectional structural view along A-A shown in FIG. 12;
FIG. 14 is a schematic structural view of a light receiving surface of a solar cell according to a sixth group of embodiments of the present application;
FIG. 15 is a schematic diagram of an arrangement structure of an isolation member and a finger of a solar cell according to a seventh group of embodiments of the present application;
FIG. 16 is a schematic diagram of another arrangement structure of an isolation member and a finger of a solar cell according to a seventh group of embodiments of the present application;
FIG. 17 is a schematic diagram of still another arrangement structure of an isolation member and a finger of a solar cell according to a seventh group of embodiments of the present application;
FIG. 18 is a schematic diagram of an arrangement structure of a finger of a solar cell according to a seventh group of embodiments of the present application;
FIG. 19 is a top view of an isolation member according to an eighth group of embodiments of the present application;
FIG. 20 is a schematic cross-sectional view of the isolation member in FIG. 19;
FIG. 21 is a schematic structural view of an isolation member according to an embodiment;
FIG. 22 is a schematic structural view of a photovoltaic module according to an eighth group of embodiments of the present application;
FIG. 23 is a schematic top view of a first solar cell according to a ninth group of embodiments of the present application;
FIG. 24 is a schematic top view of a second solar cell according to a ninth group of embodiments of the present application;
FIG. 25 is a schematic top view of a third solar cell according to a ninth group of embodiments of the present application;
FIG. 26 is a schematic diagram of a solar cell in test according to a ninth group of embodiments of the present application;
FIG. 27 is a schematic structural view of a first disposition manner of isolation bumps in a solar cell according to a tenth group of embodiments of the present application;
FIG. 28 is a schematic structural view of a second disposition manner of isolation bumps in a solar cell according to a tenth group of embodiments of the present application;
FIG. 29 is a schematic diagram of a solar cell according to an eleventh group of embodiments of the present application;
FIG. 30 is a schematic diagram of an arrangement structure of an isolation member and a finger of a solar cell according to a twelfth group of embodiments of the present application; and
FIG. 31 is a schematic diagram of another arrangement structure of an isolation member and a finger of a solar cell according to a twelfth group of embodiments of the present application.

### Reference numerals:

100-solar cell; 100a-solar cell body; 101-light receiving surface; 102-back surface; 102a-first region; 102b-second region; 102c-third region; 102d-fourth region; 102e-blank region; 103-side edge; 110-electrode; 120-isolation member; 121-first isolation member; 122-second isolation member; 123-third isolation member; 124-annular structure; 200-material box; X-first direction; Y-second direction; A-first included angle; B-second included angle; 30-first protective member; 40-second protective member; Z-third direction; D1-maximum dimension of an orthographic projection of the first protective member on the back surface along the third direction; D2-distance between two adjacent electrodes along the third direction; M-distance between two adjacent first protective members along the third direction; 300-protective adhesive layer; 301-protective adhesive unit; H-projection width of the electrode on the surface of the solar cell; 210-first isolation protrusion; 211-first insulation adhesive; 212-second insulation adhesive; 310-second isolation protrusion; 410-grid line; 411-preset position; N-thickness direction of the solar cell body; 220-insulation adhesive; 321-first busbar; 322-first finger; 323-second finger; P-direction facing away from the solar cell body; 230-isolation protrusion; 231-sub-isolation protrusion; 330-support grid line; 621-isolation bump; 63-finger; 631-first finger; 6311-first sub-finger; 632-second finger; 6321-second sub-finger; L61-distance between two adjacent isolation bumps of a same isolation member in a direction S2; L62-distance between two adjacent fingers; L63-distance between the two adjacent isolation bumps of the same isolation member in a direction S3 perpendicular to the finger; L64-distance between two adjacent first fingers; L65-distance between two adjacent second fingers; 711-peripheral portion; 7113-cavity; 712-central portion; 7121-recess; 7124-covering layer; 730-packaging adhesive film; 51-cover plate; 52-back plate; H71-minimum height of the central portion; H70-maximum height of the isolation member; 813-fifth region; 8131-third sub-region; 814-sixth region; 8141-first sub-region; 8142-second sub-region; 850-test mechanism; 851-pressing member; 852-test probe; X8-extension direction of the finger for the sixth region; 911-first side; 912-second side; X9-fourth direction; Y9-fifth direction; L92-distance between two adjacent isolation bumps along the fourth direction; L91-distance between two adjacent isolation bumps along the fifth direction; h-height of an isolation bump; 320-isolation structure; 331-first isolation structure; 332-second isolation structure; 333-third isolation structure; L32-distance between two adjacent isolation structures along the direction perpendicular to the plurality of fingers; L33-distance between centers of two adjacent isolation structures along the direction S3 perpendicular to the finger; and L34-minimum distance between centers of two isolation bumps located in two adjacent isolation structures.

### DETAILED DESCRIPTION

The embodiments of the present application are described below in detail. Examples of the embodiments are shown in the accompanying drawings. The same or similar numerals represent the same or similar elements or elements having the same or similar functions throughout the specification. The embodiments described below with reference to the accompanying drawings are exemplary, and are only used to explain the present application but should not be construed as a limitation to the present application. All other embodiments obtained by those of normal skill in the art based on the embodiments of the present application without involving any creative effort shall fall within the scope of protection of the present application.

Therefore, a feature limited by "first" or "second" in the specification and claims of the present application may explicitly or implicitly include one or more features. In the description of the present application, "a plurality of" herein means "two or more" unless otherwise described. In addition, the term "and/or" in the description and claims represents at least one of associated objects. The character "/" generally indicates an "or" relationship between the contextual objects.

In the description of the present application, it needs to be understood that orientation or position relationships indicated by terms "center", "longitudinal", "transverse", "length", "width", "thickness", "up", "down", "front", "rear", "left", "right", "vertical", "horizontal", "top", "bottom", "inside", "outside", "clockwise", "counterclockwise", "axial", "radial", and "circumferential" are based on orientation or position relationships shown in the accompanying drawings, and are only used to facilitate description of the present application and simplify description, but are not used to indicate or imply that the apparatuses or elements need to have specific orientations or are constructed and operated by using specific orientations, and therefore, cannot be understood as a limit to the present application.

In the description of the present application, it needs to be noted that unless otherwise expressly specified and defined, "mounted", "connected", and "connection" should be understood in a broad sense, for example, fixedly connected, detachably connected, or integrally connected; or mechanically connected, or electrically connected; or connected directly or through an intermediate, or two elements communicated internally. A person of normal skill in the art can understand specific meanings of the terms in the present application based on specific situations.

The following describes in detail, with reference to the accompanying drawings and by using specific embodiments and application scenarios thereof, the solar cell and the photovoltaic module provided in the embodiments of the present application.

In a first aspect, the present application provides a solar cell, including: a solar cell body, where the solar cell body has a light receiving surface and a back surface, the back surface is provided with an electrode, and the light receiving surface and/or the back surface is provided with an isolation member.

The following describes the solar cell in the first aspect of the embodiments of the present application in detail.

The solar cell (which may also be briefly referred to as a solar cell) includes a solar cell body. The solar cell body has a light receiving surface and a back surface. The light receiving surface is a surface of the solar cell that receives incident light. The back surface is a surface of the solar cell that faces away from the light receiving surface. The back surface is provided opposite to the light receiving surface. A light receiving surface of the solar cell body is the light receiving surface, and a back face of the solar cell body is the back surface.

For example, the solar cell is a back contact solar cell, and all electrodes of the back contact solar cell are provided on the back surface. The electrodes include a positive electrode and a negative electrode. In the back contact solar cell, a P region, an N region, and a grid line are all provided on the back surface of the solar cell. The light receiving surface of the back contact solar cell may be completely exposed to solar, thereby improving the light absorbing efficiency. The design of the back contact solar cell can further shorten a current transmission path, lower resistance, and improve the performance of the solar cell. During transportation of back contact solar cells, a plurality of back contact solar cells need to be stacked. In this case, a film layer of a light receiving surface of a solar cell is easily scratched by an electrode on a back surface of an adjacent solar cell. According to this embodiment of the present application, when a plurality of solar cells are stacked in a transfer process of the solar cells, because of disposition of an isolation member, there is no need to dispose an isolation paper between two adjacent solar cells, so that the technical problem of increasing production processes and affecting a production capacity because the isolation paper is placed on the solar cell and the isolation paper is taken out during subsequent production at a component end can be avoided; and the technical problem that discarding of the isolation paper causes relatively large waste in costs can be avoided.

In an embodiment, a plurality of isolation members arranged at intervals may be provided on at least one of the light receiving surface and the back surface of the solar cell body. In an embodiment, a plurality of isolation members may be provided on the light receiving surface of the solar cell body. Descriptions are provided below mainly by using an example in which the isolation member is provided on the light receiving surface of the solar cell body. When the isolation member is provided on the back surface, principles thereof are the same or similar, and details are not described herein again.

In an embodiment, a manner in which the isolation member is provided on the solar cell body is not specifically limited in this embodiment of the present application. For example, the isolation member is printed on a surface of the solar cell body. For another example, the isolation member is provided on a surface of the solar cell body in an ink-jet manner. For still another example, the isolation member is provided on a surface of the solar cell body in an adhesive dispensing manner.

In an embodiment, a plurality of isolation members arranged at intervals are provided on the light receiving surface of the solar cell body, and a plurality of electrodes are provided on the back surface of the solar cell body, and the plurality of electrodes are arranged at intervals along a third direction Z. The plurality of electrodes may be provided in parallel.

In an embodiment, the isolation member is a member made of a silicone material. In this case, the isolation member is relatively soft, and the electrode is not damaged when the isolation member is in contact with the electrode. In addition, the isolation member is a member made of a silicone material, so that illumination is substantially not affected, to avoid generation of an optical loss.

In an embodiment, the isolation member may be made of a transparent material. The isolation member may be made of a light-curing adhesive material (such as an ultraviolet curing adhesive), an evaporable adhesive material, a degradable adhesive material, an organic melt adhesive material, or the like, thereby satisfying processing requirements. In addition, the material of the used isolation member has some flexibility, thereby satisfying requirements for protecting and buffering the light receiving surface of the solar cell. The isolation member is made of a transparent material, so that the isolation member provided on the light receiving surface of the solar cell does not need to be removed subsequently. The solar cell and the isolation member are used as a whole, and the transparent isolation member does not affect a light receiving effect of the light receiving surface of the solar cell. For example, the isolation member may be made of a transparent material such as an acrylic resin, a light-sensitive adhesive, a polyolefin elastomer (POE), an ethylene vinyl acetate copolymer (EVA), a polyethylene terephthalate (PET), an insulation adhesive, or a hot-melt adhesive. It can be understood that, in a process of preparing a photovoltaic module, packaging adhesive films are usually provided on two sides of a solar cell, and a material for preparing an isolation member may be set to be the same as or similar to a material of the packaging adhesive films, so that the isolation member may be directly laminated into the photovoltaic module during the lamination, which can not only simplify operation steps, but also reduce impact of disposing the isolation member on light absorption of the solar cell. Certainly, the isolation member may alternatively be made of another type of transparent material, which is not limited in this embodiment of the present application.

In some embodiments, under a normal-temperature condition, the isolation member is a solid component. Under a high-temperature condition, the isolation member is pyrolyzed and vaporized. The high-temperature condition is at least one of a drying and curing process and a string welding process in subsequent processing of the solar cell. In the foregoing structure of this embodiment of the present application, the isolation member has some stability under the normal-temperature condition, and the isolation member is not in a melt flowing state under the normal-temperature condition. The isolation member may play a role in isolation, to avoid scratch on the surface of the solar cell body. During subsequent processing, for example, at least one of a drying and curing process and a string welding process, of the solar cell, the solar cell may be under the high-temperature condition; and the isolation member is pyrolyzed and vaporized under the high-temperature condition, the isolation member does not need to be removed additionally, and a process of subsequent transfer and processing of the solar cell is simpler, which can effectively reduce the manufacturing costs of the photovoltaic module. In addition, the isolation member has no impact on the appearance of the photovoltaic module manufactured by processing the solar cell, and existence of the isolation member cannot be detected either under intense flashlight or under an EL test.

In an embodiment, the normal temperature is not specifically limited in this embodiment of the present application. For example, the normal temperature is less than or equal to 70°C.

In some embodiments, the isolation member is made of polyvinyl alcohol (PVA). The PVA is a colorless to pale-yellow crystalline high-molecular material, and is formed by polymerizing vinyl alcohol monomers. The PVA has a melting point of approximately 100°C, and a boiling point of approximately 180°C. A PVA film is solid at the normal temperature; and after an insulation adhesive and/or a gray adhesive is applied to the component end, there is a drying and curing stage at the component end, a drying and curing temperature is 180°C to 340°C. At this stage, the PVA film is pyrolyzed, that is, the isolation member is pyrolyzed, and does not need to be removed. In addition, the PVA is a water-soluble high-molecular compound, and a coating on the light receiving surface of the solar cell body, for example, silicon nitride or silicon oxide is an organic compound. The PVA and the coating are greatly different in chemical properties and structures, and do not directly chemically react with each other. Therefore, the PVA does not affect the coating on the light receiving surface of the solar cell body.

In some embodiments, under a normal-temperature condition, the isolation member is a solid component; and in a lamination process of the subsequent processing of the solar cell, the solar cell is packaged by using the packaging adhesive film, and the isolation member is cross-linked to the packaging adhesive film. In this case, the isolation member has some stability under the normal-temperature condition, and the isolation member is not in a melt flowing state under the normal-temperature condition. The isolation member may play a role in isolation, to avoid scratch on the surface of the solar cell body. In a lamination process of the subsequent processing of the solar cell, the isolation member may be fused and cross-linked to the packaging adhesive film. Therefore, the isolation member does not need to be removed alone, and a process of subsequent transfer and processing of the solar cell is simpler, which can effectively reduce the manufacturing costs of the photovoltaic module. In addition, the isolation member has no impact on the appearance of the photovoltaic module manufactured by processing the solar cell, and existence of the isolation member cannot be detected either under intense flashlight or under an EL test.

It can be understood that, a material of the isolation member may be selected according to a use requirement. For example, at least one of a polyvinyl alcohol, an ethylenevinyl acetate copolymer, and a polyolefin elastomer is selected.

In an embodiment, a Mohs hardness of the isolation member ranges from 2 to 7. In this case, when a plurality of back contact solar cells is stacked in a transfer process of the back contact solar cells, the isolation member is in contact with a light receiving surface of an adjacent solar cell body. Because the Mohs hardness of the isolation member ranges from 2 to 7, the isolation member is softer than the light receiving surface of the solar cell body, and the isolation member having the Mohs hardness within the range of 2 to 7 does not scratch the light receiving surface of the solar cell body.

In an embodiment, to prevent the isolation member from scratching the light receiving surface of the back contact solar cell, after the isolation member is cured, a Mohs hardness of an end portion of the isolation member that faces away from the back contact solar cell is less than the Mohs hardness of the light receiving surface of the back contact solar cell, and the Mohs hardness of the end portion of the isolation member that faces away from the back contact solar cell needs to range from 2 to 7. The end portion of the isolation member facing away from the back contact solar cell is configured to come into contact with the light receiving surface of the back contact solar cell.

In an embodiment, an orthographic projection of the isolation member on the back surface at least partially overlaps with the electrode. In this way, when two solar cells are stacked, it can be ensured that an isolation member on one of the solar cells may be in contact with an electrode on the other solar cell, to play a role in isolating and supporting the two solar cells.

In an embodiment, a coverage ratio of the isolation member on at least one of the light receiving surface and the back surface is S81, where 0.5% ≤ S81 ≤ 10%.

In the present application, if the coverage ratio of the isolation member on the light receiving surface and/or the back surface is excessively small, an effect of preventing the surface of the solar cell body 100a from being scratched by the isolation member may be poor; and if the coverage ratio of the isolation member on the light receiving surface and/or the back surface is excessively large, light shielding is severe, which is not beneficial to light absorption of the solar cell body 100a. It is set that 0.5% ≤ S81 ≤ 10%, to effectively ensure an effect of preventing the surface of the solar cell body 100a from being scratched by the isolation member, and ensure a light absorbing capability of the solar cell body 100a.

Specifically, when an isolation member 120 is provided on each of the light receiving surface and the back surface, the coverage ratio of the isolation member on the light receiving surface may be the same as or different from the coverage ratio of the isolation member on the back surface. This is not specifically limited in this embodiment of the present application.

For example, the coverage ratio of the isolation member on the light receiving surface or the back surface may be 0.5%, 1.2%, 2%, 3.6%, 4.1%, 5%, 6.5%, 7%, 7.8%, 8%, 9.3%, 10%, or the like.

In an embodiment, a height h of the isolation member in a direction facing away from the solar cell body ranges from 2 µm to 80 µm. In some examples, a height h of the isolation member ranges from 15 µm to 50 µm. In some other examples, a height h of the isolation member ranges from 10 µm to 40 µm. In still some other examples, a height h of the isolation member ranges from 5 µm to 10 µm. In yet some other examples, a height h of the isolation member ranges from 3 µm to 80 µm.

For example, the height of the isolation member is any one of 2 µm, 3 µm, 5 µm, 10 µm, 15 µm, 17 µm, 20 µm, 25 µm, 30 µm, 35 µm, 40 µm, 45 µm, 48 µm, 50 µm, 60 µm, 70 µm, and 80 µm.

When h < 2 µm, the height h of the isolation member 120 is excessively small. Therefore, when adjacent solar cells are stacked, the isolation member 120 cannot effectively prevent a finger, a busbar, a terminal line, a pad, and the like on the adjacent solar cells from coming into contact with a light receiving surface 101 of a solar cell. Consequently, the anti-scratch effect may not be achieved, or the anti-scratch effect is relatively poor. When h > 80 µm, the processing difficulty of the isolation member 120 is high and the material costs are high. In this embodiment of the present application, by properly setting a height range of the isolation member 120, a function of isolating and protecting the surface of the solar cell body 100a by the isolation member 120 can be ensured.

In an embodiment, the end portion of the isolation member facing away from the back contact solar cell is a UV adhesive, the Mohs hardness of the UV adhesive ranges from 2 to 7, the UV adhesive is softer than the light receiving surface of the solar cell body, and the UV adhesive does not scratch the light receiving surface of the solar cell body, so that the UV adhesive plays a role in protection. In addition, the UV adhesive has a high light transmission rate, and basically does not affect the light-absorbing efficiency of the solar cell module.

In an implementation, the isolation member is a planar adhesive layer completely covering the light receiving surface of the solar cell. In this way, a protection area of the isolation member for the light receiving surface of the solar cell can be improved, so as to completely avoid scratch damage on the light receiving surface of the solar cell, thereby having a good protection effect.

In another implementation, the solar cell includes: a plurality of isolation members provided at intervals; and the isolation member includes: at least one of an adhesive dot (that is, a dotted protrusion), an adhesive strip (that is, an annular protrusion or a strip-shaped protrusion), and an adhesive block. In this way, the planar adhesive layer does not need to completely cover the light receiving surface of the solar cell, thereby reducing the amount of adhesive used, and reducing the production costs.

Each of the adhesive dot-type isolation members, the adhesive strip-type isolation members, and the adhesive block-type isolation members may be arranged on the light receiving surface of the solar cell in an array form.

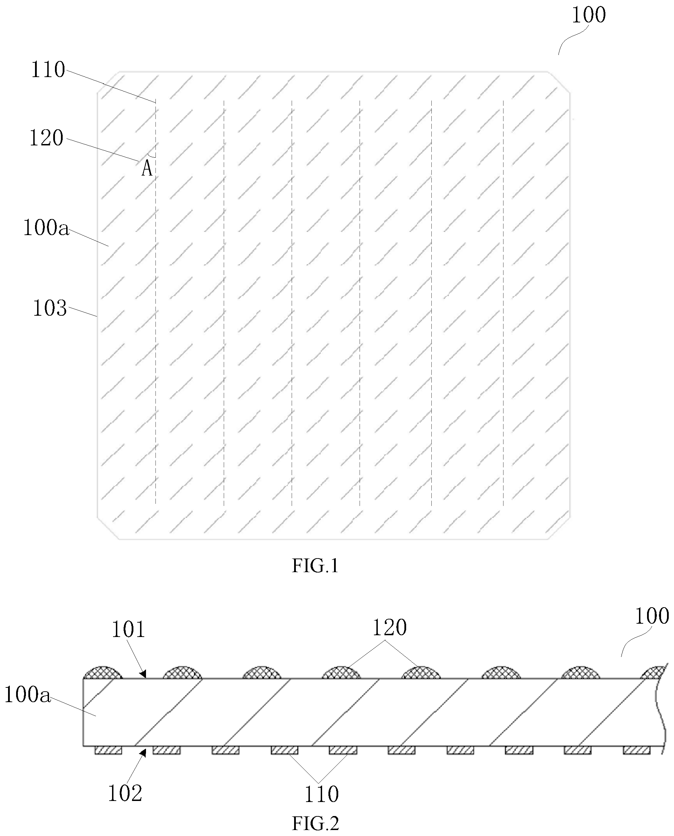

The following describes the structure of the solar cell in a first group of embodiments of the first aspect of the present application with reference to FIG. 1 to FIG. 5.

In this group of embodiments, as shown in FIG. 1 and FIG. 2, a solar cell 100 according to some embodiments of the present application includes: a solar cell body 100a, where the solar cell body 100a has a light receiving surface 101 and a back surface 102, the back surface 102 is provided with an electrode 110, the light receiving surface 101 is provided with a plurality of isolation members 120 arranged at intervals, and extension directions of at least part of the isolation members 120 are intersected with an extension direction of the electrode 110. Herein, the electrode 110 may be a busbar or a finger.

In this embodiment of the present application, a plurality of isolation members 120 arranged at intervals are provided on the light receiving surface 101 of the solar cell body 100a, so that when solar cells 100 are stacked, the isolation members 120 are used to perform isolation and support between two adjacent solar cells 100, thereby isolating and protecting the light receiving surface 101 of the solar cell 100, and preventing the light receiving surface 101 of the solar cell 100 from being scratched by an adjacent solar cell 100.

In addition, to avoid a case that an effective isolation effect cannot be achieved when electrodes 110 and isolation members 120 in the upper and lower solar cells 100 are provided in a parallel and staggered manner, in this embodiment of the present application, extension directions of at least part of the isolation members 120 are intersected with an extension direction of the electrode 110, to ensure that some of the isolation members 120 can always perform isolation and support between the light receiving surface 101 of the solar cell 100 and an electrode 110 of an adjacent solar cell 100, thereby improving a function of isolating and protecting the light receiving surface 101 of the solar cell 100. In addition, compared with disposing an isolation film layer on an entire surface, blocking on the light receiving surface 101 of the solar cell 100 can be reduced, and conversion efficiency of the solar cell 100 can be improved. It should be noted that, when a material box 200 is used to load solar cells 100, generally, a plurality of solar cells 100 are sequentially stacked into the material box 200 in such a manner that each light receiving surface 101 faces upward or each back surface 102 faces upward. For example, in this embodiment of the present application, descriptions are provided by using an example in which the plurality of solar cells 100 are loaded into the material box 200 in such a manner that each light receiving surface 101 faces upward. When the solar cells 100 are stacked in another manner, reference may be made to this example for implementation, and details are not described herein again.

As shown in FIG. 1 and FIG. 2, a plurality of isolation members 120 are provided on the light receiving surface 101 of the solar cell body 100a, and a plurality of electrodes arranged at intervals are provided on the back surface 102 of the solar cell body 100a. The isolation member 120 protrudes from the light receiving surface 101 of the solar cell body 100a to a direction away from the light receiving surface 101, so that when solar cells 100 are stacked, an adjacent solar cell 100 can be supported by using the isolation member 120, to play a role in isolating and protecting the light receiving surface 101. In addition, a plurality of isolation members 120 are arranged at intervals, so that blocking on the light receiving surface 101 can be reduced.

During specific application, a plurality of isolation members 120 are provided on the light receiving surface 101, and extension directions of different isolation members 120 may be the same or may be different, as long as it is ensured that extension directions of at least part of the isolation members 120 are intersected with the extension direction of the electrode 110 on the back surface 102.

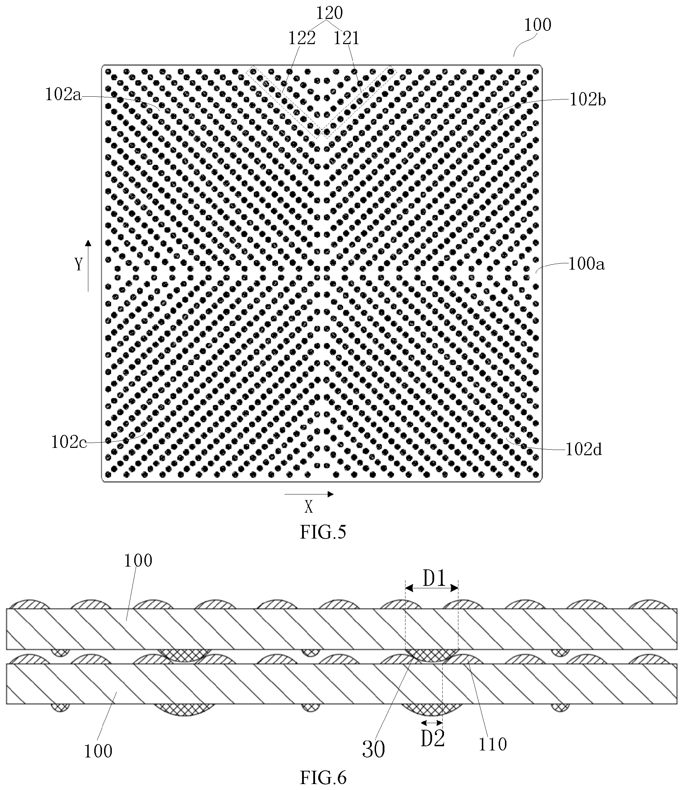

In some embodiments, as shown in FIG. 1 and FIG. 5, the isolation member 120 is formed by a plurality of dotted protrusions and/or a plurality of linear protrusions sequentially arranged at intervals along a preset direction, where the preset direction is an extension direction of the isolation member.

In this embodiment of the present application, by setting the isolation member 120 to be formed by a plurality of dotted protrusions and/or a plurality of linear protrusions sequentially arranged at intervals along a preset direction, while the surface of the solar cell 100 is isolated and protected by using the isolation member 120, the covering area of the isolation member 120 on the surface of the solar cell body 100a can be further reduced, to reduce a preparing material of the isolation member. In addition, because the refractive index of the isolation member 120 is different from the refractive index of the solar cell body 100a, a light trapping effect can be further formed by disposing dotted or linear protrusions on the surface of the solar cell body 100a, helping improve a light absorption rate of the solar cell 100, thereby improving conversion efficiency of the solar cell 100.

In addition, in a process of preparing a photovoltaic module from the solar cell 100, generally, a polymer layer usually needs to be formed on a surface of the solar cell body 100a, and the isolation member 120 is located between the polymer layer and the solar cell body 100a. Reducing a covering area of the isolation member 120 on the surface of the solar cell body 100a helps increase a contact area between the polymer layer and the solar cell body 100a, thereby reducing impact of disposing the isolation member 120 on an interfacial bonding force between the polymer layer and the solar cell body 100a.

Specifically, a plurality of isolation members 120 may be provided on the surface of the solar cell body 100a. Each isolation member 120 is formed by a plurality of dotted protrusions sequentially arranged at intervals, a plurality of linear protrusions sequentially arranged at intervals, or a plurality of dotted protrusions and a plurality of linear protrusions sequentially arranged at intervals.

For example, as shown in FIG. 5, a plurality of dotted protrusions in a dashed box forms one isolation member 120, and further, a plurality of isolation members 120 may be formed on the surface of the solar cell body. A direction in which the plurality of dotted protrusions in each isolation member 120 is sequentially arranged is an extension direction of the isolation member 120.

It should be noted that, a quantity of dotted protrusions or linear protrusions forming each isolation member 120 is not limited, and a distance between two adjacent protrusion structures (including dotted protrusions and linear protrusions) of each isolation member 120 is not limited either.

It can be understood that, when the isolation member 120 is formed by a plurality of dotted protrusions, a row formed by arranging a plurality of dotted protrusions that are close to each other is referred to as an isolation member 120. The dotted protrusion means that a difference between a dimension of a corresponding protrusion structure along an extension direction of the isolation member 120 and a dimension of the corresponding protrusion structure along a direction perpendicular to the extension direction of the isolation member 120 is relatively small. The linear protrusion means that a difference between a dimension of a corresponding protrusion structure along an extension direction of the isolation member 120 and a dimension of the corresponding protrusion structure along a direction perpendicular to the extension direction of the isolation member 120 is relatively large.

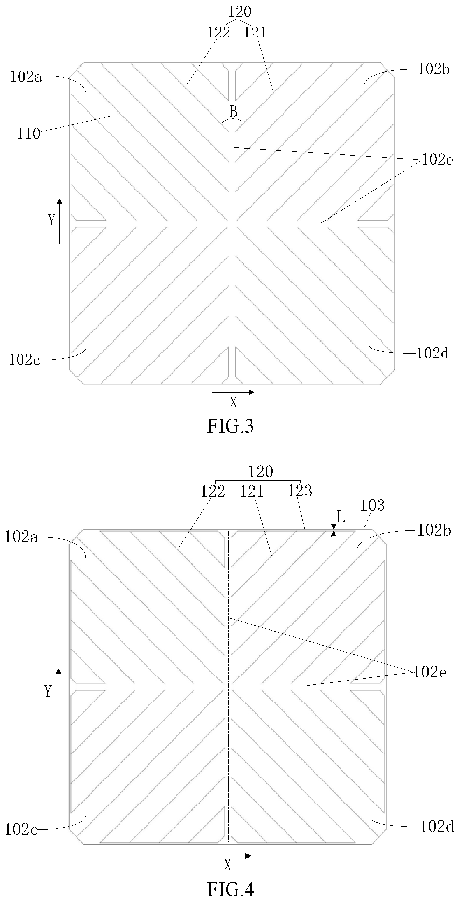

In some other embodiments, as shown in FIG. 3, the isolation member 120 is a strip-shaped protrusion extending continuously. An extension direction of the strip-shaped protrusion is an extension direction of the isolation member 120.

In this embodiment of the present application, setting the isolation member 120 as a strip-shaped protrusion extending continuously facilitates actual design and processing. In addition, the strip-shaped protrusion has a relatively large bonding force with the surface of the solar cell body 100a, and is not easily damaged during use, thereby improving an isolating and protecting effect on the solar cell.

Further, each strip-shaped protrusion may extend along a straight line, or may extend along a curved line. When the strip-shaped protrusion extends in a straight line, an extension direction of the straight line is the extension direction of the strip-shaped protrusion. However, when the strip-shaped protrusion extends in a curved line, a direction of a connection line between two opposite ends of the strip-shaped protrusion is the extension direction of the strip-shaped protrusion.

It should be noted that, that the extension direction of the isolation member 120 is intersected with the extension direction of the electrode 110 means that the extension direction of the isolation member 120 is not parallel to the extension direction of the electrode 110.

In an embodiment, the back surface 102 is provided with a busbar and a finger that are connected to each other, and the electrode 110 is a higher one of the busbar and the finger; or the back surface 102 is provided with a finger, and if no busbar is provided, the electrode 110 is the finger. The height refers to a maximum dimension of the corresponding electrode in a direction perpendicular to the back surface 102.

It should be noted that, as shown in FIG. 1, a plurality of isolation members 120 extending only in a same direction may be provided on the light receiving surface 101 of the solar cell body 100a. As shown in FIG. 3, isolation members 120 extending in different directions may alternatively be provided, and may be flexibly provided according to an actual situation. This is not limited in this embodiment of the present application.

In an embodiment, as shown in FIG. 1, a first included angle A is formed between the extension direction of the at least part of the plurality of isolation members 120 and the extension direction of the electrode 110, and the first included angle A ranges from: 30° to 150°.

In this embodiment of the present application, an angle range of a first included angle A between extension directions of at least part of the isolation members 120 and an extension direction of the electrode 110 is set, that is, at least part of the isolation members 120 are obliquely provided relative to the electrode 110, so that when a solar cell 100 that falls from above is offset, the some isolation members 120 obliquely provided can still effectively play a role in isolation and protection.

It can be understood that, in a process of loading a solar cell 100 into the material box 200, when an upper solar cell 100 slides and falls freely, a particular position offset unavoidably occurs. After research, the inventor finds that when being stacked, a solar cell 100 is generally offset at an angle not exceeding 30°. Therefore, in this embodiment of the present application, a first included angle A between an extension direction of the isolation member 120 and an extension direction of the electrode 110 is set to be between 30° and 150°. In this way, during a superimposition process, even if a solar cell 100 is offset, an electrode 110 on a surface of an upper solar cell 100 can still be isolated and supported by using the obliquely provided isolation member 120, thereby strengthening a function of isolating and protecting the light receiving surface 101 of the solar cell 100. It should be noted that, in a superimposition process in the present application, a case that an extension direction of the isolation member 120 is parallel to an extension direction of the electrode 110 because the solar cell 100 is offset needs to be avoided as much as possible. In this case, there is a possibility that the isolation member 120 is offset into a gap between electrodes 110, so that the isolation member 120 cannot effectively come into contact with or effectively support the electrode 110 on the surface. The foregoing gap between the electrodes 110 refers to a position between two adjacent electrodes 110.

Specifically, the first included angle A between the extension direction of the isolation member 120 and the extension direction of the electrode 110 may be set to: any angle such as 30°, 45°, 60°, 75°, 80°, 90°, 110°, 120°, 135°, or 150° or be within a range between any two of the angles.

In an embodiment, as shown in FIG. 1 and FIG. 3, the isolation member 120 includes a plurality of first isolation members 121 arranged at intervals, extension directions of the plurality of first isolation members 121 are the same, and the extension direction of the first isolation member 121 is intersected with the extension direction of the electrode 110. In this way, actual processing and manufacturing are facilitated, and an effective isolating and protecting function can be formed for the light receiving surface 101 by using the plurality of first isolation members 121.

In some embodiments, the solar cell body 100a has four side edges 103, and the first isolation member 121 may be a long strip-shaped protrusion structure extending continuously from one side edge 103 of the solar cell body 100a to another side edge 103; or may be a plurality of strip-shaped or dotted protrusion structures arranged and extending between two side edges 103 in a fixed direction.

In some embodiments, a distance between two adjacent electrodes 110 along a direction perpendicular to the extension direction of the electrodes 110 is a first distance; and a distance between two adjacent first isolation members 121 along a direction perpendicular to the extension direction of the first isolation members 121 is a second distance, and the second distance may be set to be less than the first distance. For example, if the first distance may be set to 15 mm, the second distance is set to be less than 15 mm.

In an embodiment, as shown in FIG. 3, the isolation member further 120 includes a plurality of second isolation members 122, the plurality of second isolation members 122 are arranged at intervals, and an extension direction of the plurality of second isolation members 122 is intersected with the extension direction of the plurality of first isolation members 121 and the extension direction of the electrode 110.

It can be understood that, if isolation members 120 extending only in a single direction are provided on the light receiving surface 101 of the solar cell 100, when a solar cell 100 that falls from above is offset by an angle during stacking, there may be a possibility that the electrode 110 on the back surface 102 of the upper solar cell 100 is exactly parallel to the isolation member 120 on the light receiving surface 101 of the lower solar cell 100. In this case, there is a possibility that the isolation member 120 is offset into a gap between the electrodes 110, so that the isolation member 120 cannot effectively isolate or support the electrode 110. Consequently, the electrode 110 directly comes into contact with the light receiving surface 101 of the lower solar cell 100, and easily scratches the light receiving surface 101 of the lower solar cell 100. It should be noted that, when the electrode 110 is a busbar, a finger is further provided at a position perpendicular to the busbar. Alternatively, the solar cell 100 may have only a finger but have no busbar. In this case, the electrode 110 is the finger. In this embodiment of the present application, by disposing the first isolation member 121 and the second isolation member 122, extension directions of the first isolation member 121 and the second isolation member 122 are both intersected with an extension direction of the electrode 110, and the extension directions of the first isolation member 121 and the second isolation member 122 are also intersected with each other. In this way, during a process of stacking solar cells 100, when a solar cell 100 that falls from above is offset, even if an electrode in the upper solar cell 100 is parallel to one of the first isolation member 121 and the second isolation member 122, the other may be used for effectively isolating and supporting the electrode 110, thereby avoiding a problem that isolation fails because the electrode 110 in the upper solar cell 100 is exactly parallel to an isolation member 120 in a lower solar cell 100, which can improve a function of isolating and protecting a surface of the solar cell 100.

It can be understood that, a plurality of first isolation members 121 and a plurality of second isolation members 122 may be set to be connected in pairs to form a network structure, thereby improving the entire structural strength of the isolation member 120 and prolonging the service life of the isolation member 120.

Certainly, the first isolation member 121 and the second isolation member 122 may alternatively be set to be not connected to each other, so as to flexibly set arrangement of the isolation member 120 on the surface of the solar cell 100. In addition, a quantity of raw materials required for preparing the isolation member 120 may also be suitably reduced.

In some embodiments, a distance between two adjacent second isolation members 122 along a direction perpendicular to the extension direction of the second isolation members 122 is a third distance, and the third distance may be set to be less than the first distance. For example, if the first distance may be set to 15 mm, the third distance is set to be less than 15 mm.

In an embodiment, as shown in FIG. 3, the extension direction of the first isolation member 121 and the extension direction of the second isolation member 122 form a second included angle B. The second included angle B ranges from: 60° to 180°. In an embodiment, the second included angle B is set to 90°. An angle range of the second included angle B is set, so that during a process of stacking solar cells 100, when a solar cell 100 is offset, the first isolation member 121 and the second isolation member 122 can play a role in effectively protecting the surface of the solar cell 100.

Specifically, the second included angle B between the extension direction of the first isolation member 121 and the extension direction of the second isolation member 122 may be set to: any angle such as 60°, 80°, 90°, 110°, 120°, 150°, or 180° or be within a range between any two of the angles.

In an embodiment, as shown in FIG. 3, the light receiving surface 101 includes four regions being respectively a first region 102a, a second region 102b, a third region 102c, and a fourth region 102d; the first region 102a and the second region 102b are arranged along a first direction X, and the third region 102c and the fourth region 102d are arranged along the first direction X; the first region 102a and the third region 102c are arranged along a second direction Y, the second region 102b and the fourth region 102d are arranged along the second direction Y, and the first direction X is perpendicular to the second direction Y; and the plurality of first isolation members 121 are provided in the second region 102b and the third region 102c, and the plurality of second isolation members 122 are provided in the first region 102a and the fourth region 102d.

In this embodiment of the present application, the light receiving surface 101 of the solar cell body 100a is divided into four regions. In the four regions, structures of isolation members 120 in two regions arranged along a diagonal line are the same, and extension directions of isolation members 120 in two adjacent regions are different. In this way, in a process of stacking solar cells 100, regardless of whether a solar cell 100 is deflected or bent, it can be ensured that isolation members 120 and electrodes 110 between two adjacent solar cells 100 can overlap to a maximum extent, thereby improving a function of isolating and protecting the light receiving surface 101 of the solar cell 100.

It should be noted that, in this embodiment of the present application, positions of the first isolation members 121 and the second isolation members 122 in the regions may be exchanged, and may be flexibly set according to an actual situation. This is not limited in this embodiment of the present application.

In an embodiment, isolation members 120 in two adjacent regions are connected to each other. In this embodiment of the present application, isolation members 120 in two adjacent regions are set to be connected to each other, to improve the overall structural strength of the isolation members 120, thereby improving the service life of the isolation members 120.

In an embodiment, as shown in FIG. 3 and FIG. 4, a blank region 102e is provided between two adjacent regions.

Specifically, blank regions 102e may be provided between the first region 102a and the third region 102c, and between the second region 102b and the fourth region 102d; or blank region 102e may be provided between the first region 102a and the second region 102b, and between the third region 102c and the fourth region 102d. No isolation member 120 is provided in the blank regions 102e, so that in a processing process of a solar cell, the solar cell 100 may be cut from the blank regions 102e to form a half solar cell 100.

In an embodiment, as shown in FIG. 3, the plurality of isolation members 120 on the light receiving surface 101 are axially symmetrically arranged.

In this embodiment of the present application, the plurality of isolation members 120 on the light receiving surface 101 are set to be axially symmetrically arranged, to make an arrangement structure of the isolation members 120 on the surface of the solar cell 100 more regular, so that when an upper solar cell is offset during a stacking process, an isolation member 120 in at least one region can isolate and support the upper solar cell 100, thereby ensuring an isolation and protection function on the light receiving surface 101 of the solar cell 100.

Specifically, a first axis extending along the first direction X may be set beyond a central point of the light receiving surface 101, and the plurality of isolation members 120 on the light receiving surface 101 are axially symmetrically arranged by using the first axis as an axis of symmetry; or a second axis extending along the second direction Y may be set beyond a central point of the light receiving surface 101, and the plurality of isolation members 120 on the light receiving surface 101 are axially symmetrically arranged by using the second axis as an axis of symmetry. During specific application, the solar cell may be cut by using the first axis or the second axis as a reference to obtain a half solar cell.

In an embodiment, as shown in FIG. 4, the isolation member 120 further includes a third isolation member 123. The third isolation member 123 is provided around at least a part of a peripheral edge of the light receiving surface 101. The third isolation member 123 is connected to the first isolation member 121 and/or the second isolation member 122.

It can be understood that, when a solar cell 100 is stacked into the material box 200, a transfer mechanism needs to be used to extract the solar cell 100 for transfer. The transfer mechanism is provided with an adsorption plane, and the adsorption plane is provided with a plurality of adsorption holes. During a transfer operation, the adsorption plane of the transfer mechanism comes into contact with the light receiving surface 101 of the solar cell 100, and a negative pressure is provided through the plurality of adsorption holes to adsorb and fix the solar cell 100 by using the adsorption plane. When an isolation member 120 is provided on the light receiving surface 101, because the isolation member 120 protrudes from the light receiving surface 101, a degree of adhesion between the adsorption plane of the transfer mechanism and the light receiving surface 101 of the solar cell 100 is affected, thereby affecting a vacuum adsorption effect of the transfer mechanism on the solar cell 100.

Therefore, in this embodiment of the present application, the third isolation member 123 is provided on a peripheral edge of the light receiving surface 101, the third isolation member 123 is provided around at least a part of the peripheral edge of the light receiving surface 101, and the third isolation member 123 is connected to the first isolation member 121 and/or the second isolation member 122. In this way, when the adsorption plane of the transfer mechanism is in contact with the isolation member 120 on the surface of the solar cell 100, a closed or semi-closed space is locally formed, helping improve a vacuum adsorption effect.

Specifically, the solar cell body 100a has four side edges 103. A third isolation member 123 may be provided at a position corresponding to each side edge 103. The third isolation member 123 is parallel to the corresponding side edge 103. Third isolation members 123 respectively corresponding to two adjacent side edges 103 may be connected to each other or may not be connected to each other.

In addition, a strengthening protrusion may also be provided at a blank position of an edge of the light receiving surface 101, so that the strengthening protrusion is connected to the first isolation member 121 and/or the second isolation member 122 at a corresponding position, to strengthen an isolating and protecting effect on an edge region. A specific structure of the strengthening protrusion may be flexibly provided according to an actual situation. This is not limited in this embodiment of the present application.

In an embodiment, the light receiving surface 101 is provided with a plurality of regions, an isolation member 120 is provided in each region, and extension directions of isolation members 120 in two adjacent regions are staggered.

In this embodiment of the present application, the light receiving surface 101 is divided into a plurality of regions, an isolation member 120 is provided in each region, and extension directions of isolation members 120 in two adjacent regions are staggered. In this way, in a process of stacking solar cells 100, no matter how a solar cell 100 falling from above is offset or inclined, there are always some isolation members 120 that can effectively isolate and support an electrode 110 or an edge of the upper solar cell 100, thereby improving a function of isolating and protecting a surface of the solar cell 100.

The following describes the structure of the solar cell in a second group of embodiments of the first aspect of the present application with reference to FIG. 6 to FIG. 7.

In this group of embodiments, a plurality of electrodes sequentially arranged at intervals along a third direction are provided on the back surface, and the isolation member includes a first protective member. As shown in FIG. 6, a solar cell 100 according to some embodiments of the present application includes a solar cell body 100a, where the solar cell body 100a has a light receiving surface 101 and a back surface 102, a plurality of electrodes 110 sequentially arranged at intervals along a third direction Z are provided on the back surface 102, at least one of the light receiving surface 101 and the back surface 102 is provided with a plurality of first protective members 30 that are arranged at intervals, and a maximum dimension of an orthographic projection of the first protective member 30 on the back surface 102 along the third direction Z is greater than a distance between two adjacent electrodes 110.

In this embodiment of the present application, when a stacking operation is performed on solar cells 100, a plurality of first protective members 30 can play a role in isolating and supporting two adjacent solar cells 100. Compared with the related art in which an isolating adhesive film is provided on an entire surface, a covering area on the light receiving surface 101 of the solar cell 100 can be reduced, thereby reducing a light shielding rate on the light receiving surface 101. On the premise that a function of isolating and protecting the light receiving surface 101 is satisfied, conversion efficiency of the solar cell 100 can be effectively improved.

The electrode 110 in this embodiment of the present application may be a busbar or a finger provided on the back surface 10b. The busbar may also be referred to as a busbar, and the finger may also be referred to as a finger. Usually, when two solar cells 100 are stacked up and down, a busbar or a finger is supported between the two solar cells 100 to serve as a support grid line, and the support grid line may be set as an electrode 110.

The light receiving surface 101 and the back surface 102 of the solar cell body 100a may be considered as two parallel planes. In a direction perpendicular to the back surface 102, each first protective member 30 is projected on the back surface 102 to form a projection pattern. The length dimension of the projection pattern along the arrangement direction of the plurality of electrodes 110 (that is, along the third direction Z) may be measured, a plurality of length dimension values is obtained by measurement, and a maximum value of the plurality of length dimension values is used as a measurement value of a maximum dimension of the projection pattern along the third direction Z, that is, a maximum dimension D1 of an orthographic projection of the first protective member 30 on the back surface 102 along the third direction Z. Correspondingly, a distance between two adjacent electrodes 110 along the third direction Z is D2, and D1>D2 is set.

In some embodiments, as shown in FIG. 6, a maximum dimension D1 of an orthographic projection of the first protective member 30 on the back surface 102 along the third direction Z is set to be greater than a distance D2 between two adjacent electrodes 110. In this way, when two solar cells 100 are stacked and placed, a first protective member 30 in one solar cell 100 can be prevented from directly falling into a place between two adjacent electrodes 110 on the other solar cell 100, thereby ensuring that the first protective member 30 can always be isolated and supported on the electrode 110 of the other solar cell 100 during a stacking process, to further effectively reduce a risk that the light receiving surface 101 of the solar cell 100 directly comes into contact with the electrode 110 of the other solar cell 100 and is scratched by friction.

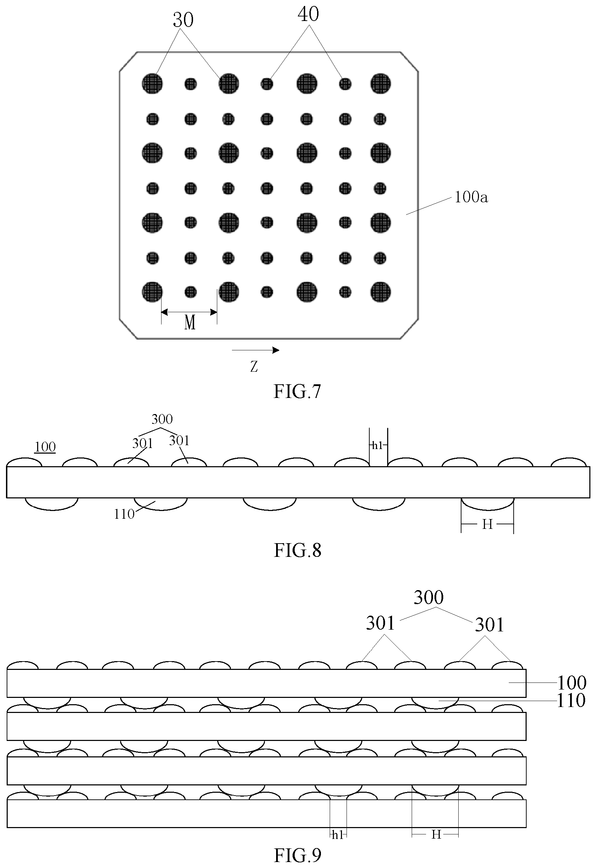

In an embodiment, as shown in FIG. 7, the first protective member 30 is a dotted protrusion; or the first protective member 30 is an annular protrusion, or the first protective member 30 is a strip-shaped protrusion. In an embodiment, as shown in FIG. 6, a maximum dimension of an orthographic projection of the first protective member 30 on the back surface 102 along the third direction Z is D1, and a distance between two adjacent electrodes 110 is D2, satisfying: 1/30<D1/D2≤20/3.

In this way, it can be ensured that an effective isolating and supporting function can be formed for electrodes 110 on adjacent solar cells 100 by using the first protective member 30 during stacking, and a case that an excessively large dimension of the first protective member 30 increases production costs and increases blocking on the light receiving surface 101 of the solar cell 100 can be avoided. In some examples, 1 < D1/D2 ≤ 2.

For example, a ratio D1/D2 of a maximum dimension D1 of an orthographic projection of the first protective member 30 on the back surface 102 along the third direction Z to a distance D2 between two adjacent electrodes 110 may be set to: any value such as 1/30, 0.2, 0.6, 0.5, 1.1, 1.3, 1.5, 1.6, 1.8, 2.0, 4.0, 5.0, or 20/3 or be within a range between any two of the values.

In an embodiment, as shown in FIG. 7, a distance between two adjacent first protective members 30 along the third direction Z is M, satisfying: M ≤ 8 mm.

Because a solar cell 100 usually has a flexible deformation capability, when solar cells 100 are stacked, if a distance between two adjacent first protective members 30 is excessively large, a part of a solar cell 100 located between the two first protective members 30 may be bent under the effect of gravity, and the bent part of the solar cell 100 is easy to come into contact with an electrode 110 of another solar cell 100, to scratch a light receiving surface 101 of the solar cell 100. Within the value range, a case that the distance between the two first protective members 30 is excessively large and therefore the solar cell 100 cannot be effectively isolated or protected can be avoided.

For example, a distance M between two adjacent first protective members 30 may be set to: any value such as 1 mm, 2 mm, 3 mm, 4 mm, 5 mm, 6 mm, 7 mm, or 8 mm or be within a range between any two of the values.

In an embodiment, as shown in FIG. 7, the isolation member further includes a second protective member 40. The second protective member 40 is intersected with the first protective member 30, and an area of an orthographic projection of the second protective member 40 on the light receiving surface 101 is less than an area of an orthographic projection of the first protective member 30 on the light receiving surface 101. The distance region of the first protective member 30 is strengthened and protected by using the second protective member 40. In this way, through cooperation between the first protective member 30 and the second protective member 40, the light receiving surface 101 of the solar cell 100 can be isolated and protected to a maximum extent by using relatively few preparing raw materials.

In some embodiments, as shown in FIG. 7, the second protective member 40 may be set to at least one of a dotted protrusion, an annular protrusion, and a strip-shaped protrusion, so that the second protective member 40 can be used to strengthen and protect the surface of the solar cell 100, and facilitate actual design and processing.

As described above, the first protective member 30 may be made of a transparent material, for example, may be made of a transparent material such as a light-sensitive adhesive, a polyolefin elastomer (POE), an ethylene vinyl acetate copolymer (EVA), a polyethylene terephthalate (PET), an insulation adhesive, or a hot-melt adhesive. Certainly, the first protective member 30 may alternatively be made of another type of transparent material. This is not limited in this embodiment of the present application. The second protective member 40 and the first protective member 30 may be made of a same material, or may be made of different materials.

In an embodiment, along a direction perpendicular to the light receiving surface 101, heights of the first protective member 30 and the second protective member 40 are equal, so that when solar cells 100 are stacked, the first protective member 30 and the second protective member 40 can simultaneously come into contact with a grid line or a back surface 102 of an adjacent solar cell 100, thereby improving a function of isolating and protecting a surface of the solar cell 100.

Certainly, the heights of the first protective member 30 and the second protective member 40 may alternatively be set to be not equal.

In an embodiment, as shown in FIG. 7, the plurality of first protective members 30 are arranged in an array. In an embodiment, as shown in FIG. 7, the plurality of second protective members 40 are arranged in an array.

In an embodiment, an insulation adhesive layer is further provided on the back surface 102 of the solar cell body 100a, the insulation adhesive layer covers at least part of the electrodes 110, and an orthographic projection of the first protective member 30 on the back surface 102 is intersected with the insulation adhesive layer; and/or an orthographic projection of the second protective member 40 on the back surface 102 is intersected with the insulation adhesive layer.

Specifically, in the back contact solar cell 100, a positive electrode and a negative electrode are both provided on a back surface 102 of the solar cell 100. When a plurality of solar cells 100 are connected to form a solar cell string, a welding strip usually needs to be used to weld electrodes 110 in two adjacent solar cells. To reduce a risk that a short circuit occurs between the positive electrode and the negative electrode when the welding strip is offset, an insulation adhesive layer is usually provided on the back surface 102, and the insulation adhesive layer partially covers the electrodes 110, so as to play a role in insulation and isolation between the positive electrode and the negative electrode.

When solar cells 100 are stacked, if the first protective member 30 and/or the second protective member 40 are in contact with the insulation adhesive layer, an interval between two solar cells 100 is excessively large, which easily causes excessive deformation of an unsupported part of the solar cells. Therefore, in this embodiment of the present application, the orthographic projection of the first protective member 30 and/or the second protective member 40 on the back surface 102 is set to be intersected with the insulation adhesive layer. In this way, when solar cells 100 are stacked, it can be ensured that a first protective member 30 and/or a second protective member 40 in one of the solar cells 100 is not in contact with an insulation adhesive layer on the other solar cell 100, thereby helping reduce a dimension of an interval between the two solar cells 100.

The following describes the structure of the solar cell in a third group of embodiments of the first aspect of the present application with reference to FIG. 8 to FIG. 9.

In this group of embodiments, the isolation member is a protective adhesive unit. Referring to FIG. 8, an embodiment of the present application provides a solar cell (which may also be referred to as a solar cell body) 100. A protective adhesive layer 300 is provided on at least one of a back surface (that is, a back face) and a light receiving surface (that is, a light receiving surface) of the solar cell 100 (as shown in the figure, the protective adhesive layer 300 is provided on the light receiving surface of the solar cell 100), the back surface is provided with a plurality of electrodes 110, and the protective adhesive layer 300 includes a plurality of protective adhesive units 301 provided at intervals; and a minimum distance h1 between two adjacent protective adhesive units 301 is less than a projection width H of the electrode 110 on the solar cell 100 on the surface of the solar cell 100.

In this embodiment of the present application, a protective adhesive layer 300 may be provided on a light receiving surface of a solar cell 100, so that when a plurality of solar cells 100 are stacked, each electrode 110 on a back surface of one solar cell 100 may be supported by two adjacent protective adhesive units 301 corresponding to a light receiving surface of another adjacent solar cell 100. A suitable distance between the two adjacent protective adhesive units 301 may enable an electrode 110 on a back surface of one solar cell 100 not to be in direct contact with a light receiving surface of another adjacent solar cell 100, so that the light receiving surface of the solar cell is not scratched due to contact of the electrode, thereby protecting the surface of the solar cell.

Referring to FIG. 9, an embodiment of the present application further provides a schematic structural diagram of a solar cell stack structure. The solar cell stack structure includes: a plurality of solar cells 100 that are stacked, where a back surface of the solar cell 100 is provided with an electrode 110. In the solar cell stack structure, a back surface of one solar cell 100 is provided opposite to a light receiving surface of another adjacent solar cell 100. A protective adhesive layer 300 is provided on a light receiving surface of the solar cell 100. The protective adhesive layer 300 includes a plurality of protective adhesive units 301 provided at intervals. For two adjacent solar cells 100 in the solar cell stack structure, each electrode 110 on a back surface of one solar cell 100 has two corresponding adjacent protective adhesive units 301 on a light receiving surface of the other solar cell 100, and a minimum distance h1 between the two adjacent protective adhesive units 301 is less than a projection width H of the electrode 110 on the back surface of the solar cell 100.

Through such a design, the light receiving surface of the solar cell is not scratched due to contact of the electrode, thereby protecting the surface of the solar cell. In addition, the protective adhesive layer is fixed to the light receiving surface of the solar cell. The protective adhesive layer is not prone to fall off or have a position offset, so that the protective adhesive layer can produce a continuous protective effect on the surface of the solar cell. Through the design of the protective adhesive units 301 provided at intervals, a relatively small amount of adhesive is used.

In an embodiment, the electrode 110 includes a terminal line, a welding point (that is, a pad, also referred to as a pad point), and a finger, and the terminal line is electrically connected to a part of the finger; and the minimum distance between the two adjacent protective adhesive units 301 is less than a projection width of a highest one of the terminal line, the welding point, and the finger on the back surface of the solar cell.

In an embodiment, the electrode includes a welding point, a busbar, and a finger; and the minimum distance between the two adjacent protective adhesive units is less than a projection width of a highest one of the welding point, the busbar, and the finger on the back surface of the solar cell.

In an embodiment, the electrode includes a welding point and a finger; and the minimum distance between the two adjacent protective adhesive units is less than a projection width of a higher one of the welding point and the finger on the back surface of the solar cell.

In an embodiment, the electrode 110 includes a busbar and a finger; and if a protrusion height of the busbar is greater than a protrusion height of the finger, a minimum distance between two adjacent protective adhesive units 301 is less than a projection width of the busbar on the back surface of the solar cell 100; or if a protrusion height of the busbar is less than a protrusion height of the finger, a minimum distance between two adjacent protective adhesive units 301 is less than a projection width of the finger on the back surface of the solar cell 100.

For a back contact solar cell, an electrode of the back contact solar cell may specifically include a busbar and a finger. The busbar is perpendicular to the finger.

There is a case that a protrusion height of the busbar of the solar cell 100 is greater than a protrusion height of the finger. In this case, when two adjacent solar cells 100 are stacked, a busbar of a back surface of one solar cell 100 first comes into contact with and supports two adjacent protective adhesive units 301 corresponding to a light receiving surface of the other solar cell 100. Because the finger has a relatively small height, the finger does not contact a light receiving surface of the other facing solar cell 100 on the premise that the busbar has formed a support, so as to avoid a case that an electrode of one solar cell directly contacts the light receiving surface of the other solar cell, thereby resolving a problem that the electrode of the one solar cell scratches the light receiving surface of the other solar cell. Therefore, an effect of protecting the surface of the solar cell is improved.

There is a case that a protrusion height of the busbar of the solar cell 100 is less than a protrusion height of the finger. In this case, when two adjacent solar cells 100 are stacked, a finger of a back surface of one solar cell 100 first comes into contact with and supports two adjacent protective adhesive units 301 corresponding to a light receiving surface of the other solar cell 100. Because the busbar has a relatively small height, the busbar does not contact a light receiving surface of the other facing solar cell 100 on the premise that the finger has formed a support, so as to avoid a case that an electrode of one solar cell directly contacts the light receiving surface of the other solar cell, thereby resolving a problem that the electrode of the one solar cell scratches the light receiving surface of the other solar cell. Therefore, an effect of protecting the surface of the solar cell is improved.

In an embodiment, the electrode 110 includes a welding point, a busbar, and a finger; and if a protrusion height of the welding point is greater than a protrusion height of the busbar and the finger, a minimum distance between two adjacent protective adhesive units 301 is less than a projection width of the welding point on the back surface of the solar cell.

In an implementation of this embodiment of the present application, in addition to the busbar and the finger, the electrode 110 may further include a welding point. The welding point is a pad, and is specifically used for welding the electrode 110. Therefore, if a protrusion height of the welding point is greater than a protrusion height of the busbar and the finger, when two adjacent solar cells 100 are stacked, a welding point of a back surface of one solar cell 100 first comes into contact with and supports two adjacent protective adhesive units 301 corresponding to a light receiving surface of the other solar cell 100. Because the busbar and the finger have a relatively small height, the busbar and the finger do not contact a light receiving surface of the other facing solar cell 100 on the premise that the welding point has formed a support, so as to avoid a case that an electrode of one solar cell directly contacts the light receiving surface of the other solar cell, thereby resolving a problem that the electrode of the one solar cell scratches the light receiving surface of the other solar cell. Therefore, an effect of protecting the surface of the solar cell is improved.

In an embodiment, the electrode includes only a finger; and a minimum distance between two adjacent protective adhesive units is less than a projection width of the finger on the back surface of the solar cell.

In an embodiment, a weight of a single protective adhesive unit is less than or equal to 15 mg, and a basic supporting function of the protective adhesive unit can be implemented based on reducing the amount of adhesive.

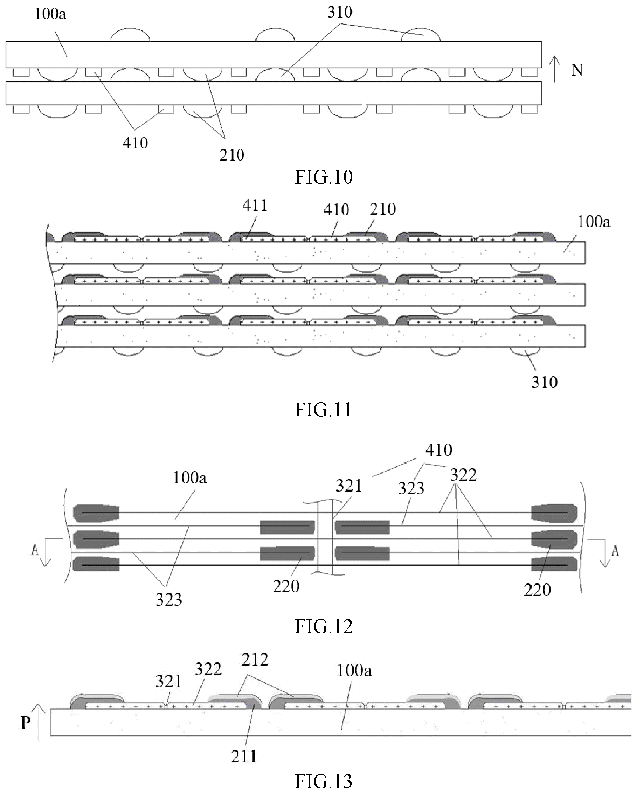

The following describes the structure of the solar cell in a fourth group of embodiments of the first aspect of the present application with reference to FIG. 10 to FIG. 11.

In this group of embodiments, the solar cell includes a plurality of first isolation protrusions 210, a plurality of second isolation protrusions 310, a plurality of grid lines 410, and a solar cell body 100a; the plurality of first isolation protrusions 210 are provided on the back surface 102 (that is, a back face) of the solar cell body, and the first isolation protrusions 210 protrude from the back surface 102 of the solar cell body; the plurality of second isolation protrusions 310 are provided on the light receiving surface 101 (that is, a light receiving surface) of the solar cell body, and the second isolation protrusions 310 protrude from the light receiving surface 101 of the solar cell body; the plurality of grid lines 410 are provided on at least one surface of the solar cell body; in a thickness direction of the solar cell body 100a (that is, in a direction N in FIG. 10), a height of at least one of the plurality of first isolation protrusions 210 and the plurality of second isolation protrusions 310 is greater than heights of all of the grid lines 410; and projections of the plurality of second isolation protrusions 310 on the back surface 102 of the solar cell body do not intersect with the first isolation protrusions 210, or the projections of the plurality of second isolation protrusions 310 on the back surface 102 of the solar cell body are partially intersected with the plurality of first isolation protrusions 210. That is, the second isolation protrusions 310 and the first isolation protrusions 210 are staggered, and are not correspondingly provided.

Solar cells have a plurality of types. For example, the solar cell includes a busbar and a finger, and a height of the busbar is greater than a height of the finger, or a height of the busbar is less than a height of the finger. For another example, the solar cell includes a plurality of fingers.

In this embodiment of the present application, in a thickness direction of the solar cell body 100a (that is, in a direction N in FIG. 10), a height of at least one of the plurality of first isolation protrusions 210 and the plurality of second isolation protrusions 310 is greater than heights of all of the grid lines 410.

In a process of transferring solar cells in this embodiment of the present application, a plurality of solar cells is stacked, and a back surface of one solar cell is in contact with a light receiving surface of another solar cell. In a thickness direction of the solar cell body 100a, a height of at least one of the plurality of first isolation protrusions 210 and the plurality of second isolation protrusions 310 is greater than heights of all the grid lines 410. Therefore, there is a gap between a grid line 410 of one solar cell and a surface of another solar cell, the grid line 410 is not in contact with a surface of an adjacent solar cell body 100a, and the grid line 410 does not scratch the surface of the adjacent solar cell body 100a, thereby effectively reducing the possibility of scratching the surface of the solar cell body 100a during the transfer of the solar cells. The second isolation protrusion 310 is provided on the light receiving surface 101 of the solar cell body, the first isolation protrusion 210 is provided on the back surface 102 of the solar cell body, and the second isolation protrusion 310 and the first isolation protrusion 210 can achieve a double isolation function, thereby more effectively preventing the grid line 410 from coming into contact with the surface of the solar cell body.

In an embodiment, a grid line 410 is provided on the back surface 102 of the solar cell body, and the first isolation protrusion 210 is an insulation adhesive. Referring to FIG. 11, the insulation adhesive is connected to a preset position 411 of the grid line 410. The insulation adhesive is usually provided in the back contact solar cell, and the insulation adhesive is used to prevent a short circuit between two types of grid lines 410 of opposite polarities on the back surface 102 of the solar cell body. When the first isolation protrusion 210 is the insulation adhesive, the first isolation protrusion 210 does not need to be additionally provided, thereby reducing an amount of glue and process steps, and reducing production costs.

In this embodiment of the present application, the preset position of the grid line 410 is a position at which a short circuit is prone to occur between two types of grid lines 410 of opposite polarities. For example, the preset position is an end portion of the grid line 410.

In an embodiment, the back surface 102 of the solar cell body is provided with a grid line 410, and the first isolation protrusion 210 is an insulation adhesive. The insulation adhesive is located in a gap between two adjacent grid lines 410. In this case, impact of the insulation adhesive on subsequent processing and use of the grid lines 410 can be avoided.

In an embodiment, a grid line 410 is provided on the back surface 102 of the solar cell body, and the first isolation protrusion 210 is an insulation adhesive. The insulation adhesive is connected to a preset position 411 of the grid line 410, and the insulation adhesive is located in a gap between two adjacent grid lines 410.

The following describes the structure of the solar cell in a fifth group of embodiments of the first aspect of the present application with reference to FIG. 12 to FIG. 13.

In this group of embodiments, the solar cell is a back contact solar cell; the isolation member includes an insulation adhesive; the electrode includes grid lines. Referring to FIG. 12, the back contact solar cell includes a solar cell body 100a, an insulation adhesive 220, and a grid line 410, and the insulation adhesive 220 and the grid line 410 are provided on a back surface of the solar cell body 100a; and in a direction away from the solar cell body 100a, a height of the insulation adhesive 220 is greater than a height of the grid line 410, and a Mohs hardness of an end portion of the insulation adhesive 220 that faces away from the back contact solar cell ranges from 2 to 7.

The insulation adhesive 220 of the back contact solar cell has a plurality of use structures. This is not specifically limited in this embodiment of the present application. For example, when the grid line 410 includes a finger and a busbar, the insulation adhesive 220 is connected to the finger, to prevent a short circuit from occurring due to the finger. For example, the grid line 410 includes a finger and does not include a busbar. The finger outputs electric energy through a welding strip. In this case, the insulation adhesive 220 may be connected to the welding strip, and the insulation adhesive 220 is used for fixing the welding strip, or preventing a short circuit from occurring at the welding strip. For example, the grid line 410 includes a finger and does not include a busbar. To prevent a short circuit from occurring due to the finger, an insulation adhesive 220 is provided on an end portion of the finger. For another example, the insulation adhesive 220 is not connected to the welding strip, the grid line 410, or the like, and the insulation adhesive 220 is connected to only the back surface of the solar cell body 100a.

According to the back contact solar cell in this embodiment of the present application, in a direction facing away from the solar cell body 100a, a height of the insulation adhesive 220 is greater than a height of the grid line 410. When a plurality of back contact solar cells is stacked in a process of transferring back contact solar cells, the insulation adhesive 220 is in contact with a light receiving surface of an adjacent solar cell body 100a. Because the Mohs hardness of the end portion of the insulation adhesive 220 facing away from the back contact solar cell ranges from 2 to 7, the end portion of the insulation adhesive 220 is softer than the light receiving surface of the solar cell body 100a, and the end portion of the insulation adhesive 220 does not scratch the light receiving surface of the solar cell body 100a. In addition, the grid line 410 does not protrude from the insulation adhesive 220 to scratch the light receiving surface of the adjacent solar cell body 100a. Setting of the insulation adhesive 220 effectively reduces a possibility of damaging the light receiving surface in a process of transferring back contact solar cells. In addition, the insulation adhesive 220 is provided on the back surface of the solar cell body 100a, so that the insulation adhesive 220 can be prevented from blocking light, thereby ensuring the optical-to-electrical conversion efficiency of the back contact solar cell. It should be noted that, it is not the case that the end portion of the insulation adhesive 220 that faces away from the back contact solar cell does not scratch the light receiving surface of the adjacent solar cell body 100a provided that the Mohs hardness of the end portion of the insulation adhesive 220 that faces away from the back contact solar cell is less than the Mohs hardness of the light receiving surface of the solar cell body 100a, but instead, the light receiving surface of the adjacent solar cell body 100a is not scratched only when the Mohs hardness of the end portion of the insulation adhesive 220 that faces away from the back contact solar cell ranges from 2 to 7. Generally, on the light receiving surface of the solar cell body 100a, silicon nitride is used as a passivation layer, and the Mohs hardness of the silicon nitride ranges from 9 to 9.5. When the Mohs hardness of the end portion of the insulation adhesive 220 that faces away from the back contact solar cell ranges from 2 to 7, a difference between the Mohs hardness of the end portion and the Mohs hardness of the light receiving surface of the solar cell body 100a disables the end portion of the insulation adhesive 220 from scratching the light receiving surface of the solar cell body 100a.

In an embodiment, there is a plurality of grid lines 410 (for example, a first busbar 321, a first finger 322, and a second finger 323 in FIG. 12); and in a direction away from the solar cell body 100a, a height of the insulation adhesive 220 is greater than heights of all the grid lines 410.

FIG. 13 is a schematic structural diagram of a cross-sectional view A-A in FIG. 12 and a schematic structural diagram of a cross-sectional view extending to a right side (a part is not shown) of FIG. 12. The insulation adhesive 220 includes a first insulation adhesive 211 and a second insulation adhesive 212; and the first insulation adhesive 211 is connected to the back surface of the back contact solar cell and covers at least part of the grid line 410, and the second insulation adhesive 212 covers a surface of at least a part of the first insulation adhesive 211.

In the back contact solar cell in this embodiment of the present application, to avoid a short circuit, at least part of the grid line 410 needs to be covered with the first insulation adhesive 211. There are two cases in which the second insulation adhesive 212 covers a surface of at least a part of the first insulation adhesive 211: When the second insulation adhesive 212 covers a part of the surface of the first insulation adhesive 211, the second insulation adhesive 212 can reduce a quantity of the second insulation adhesive 212 and save production costs while preventing the light receiving surface of the solar cell body 100a from being scratched by a grid line 410 on a back surface of an adjacent solar cell body 100a. If the second insulation adhesive 212 covers all of the surface of the first insulation adhesive 211, there are more contact points between the second insulation adhesive 212 and the light receiving surface of the solar cell body 100a, thereby more reliably preventing the grid line 410 from scratching the light receiving surface of the solar cell body 100a.

In an embodiment, the insulation adhesive 220 includes a first insulation adhesive 211 and a second insulation adhesive 212; and the first insulation adhesive 211 is connected to the back surface of the back contact solar cell and covers at least part of the grid line 410; and the second insulation adhesive 212 has a bump-shaped structure, and is connected to at least part of a surface of the first insulation adhesive 211 that faces away from the solar cell body 100a. The second insulation adhesive 212 has a bump-shaped structure, so that a quantity of the second insulation adhesive 212 is reduced, thereby reducing production costs. When the second insulation adhesive 212 is connected to a part of the surface of the first insulation adhesive 211 that faces away from the solar cell body 100a, a quantity of the second insulation adhesive 212 can be further reduced, thereby further reducing production costs. If the second insulation adhesive 212 is connected to all of the surface of the first insulation adhesive 211 that faces away from the solar cell body 100a, there are more contact points between the second insulation adhesive 212 and the light receiving surface of the solar cell body 100a, thereby more reliably preventing the grid line 410 from scratching the light receiving surface of the solar cell body 100a.

In an embodiment, to prevent the insulation adhesive 220 from scratching the light receiving surface of the back contact solar cell, after the insulation adhesive 220 is cured, a Mohs hardness of an end portion of the insulation adhesive 220 that faces away from the back contact solar cell is less than the Mohs hardness of the light receiving surface of the back contact solar cell, and the Mohs hardness of the end portion of the insulation adhesive 220 that faces away from the back contact solar cell needs to range from 2 to 7. The end portion of the insulation adhesive 220 facing away from the back contact solar cell is configured to come into contact with the light receiving surface of the back contact solar cell.

In an embodiment, the insulation adhesive 220 includes a first insulation adhesive 211 and a second insulation adhesive 212, and the first insulation adhesive 211 is connected to the back surface of the solar cell body and covers a preset position of the grid line; and the second insulation adhesive 212 is connected to at least part of the first insulation adhesive 211, and covers a surface of the first insulation adhesive 211 that faces away from the solar cell body.

In an embodiment, the insulation adhesive 220 includes a first insulation adhesive 211, and the first insulation adhesive 211 is connected to the back surface of the back contact solar cell and covers at least part of the grid line.

As described above, a height h of the isolation member ranges from 2 µm to 80 µm.

In some examples, a height of the insulation adhesive in a direction facing away from the solar cell body ranges from 15 µm to 50 µm. It can be understood that, a range of a height of the insulation adhesive 220 is specifically selected according to a use requirement. For example, the range of the height of the insulation adhesive 220 is any value of 15 µm, 17 µm, 20 µm, 25 µm, 30 µm, 35 µm, 40 µm, 45 µm, 48 µm, and 50 µm.

In some examples, a range of a thickness of the first insulation adhesive 211 is 10 µm to 40 µm. When the thickness of the first insulation adhesive 211 is within the foregoing range, the amount of the first insulation adhesive 211 is reduced as much as possible while achieving a good isolating effect, to reduce production costs. It can be understood that, a thickness of the first insulation adhesive 211 is specifically selected according to a use requirement. For example, the thickness of the first insulation adhesive 211 is any value of 10 µm, 15 µm, 18 µm, 20 µm, 25 µm, 30 µm, 35 µm, 38 µm, and 40 µm.

In some examples, a range of a thickness of the second insulation adhesive 212 is 5 µm to 10 µm. If the thickness of the second insulation adhesive 212 is within the foregoing range, when the second insulation adhesive 212 is in contact with the light receiving surface of the solar cell body 100a, the light receiving surface of the solar cell body 100a can be prevented from being damaged, and a thickness of the back contact solar cell can be prevented from being increased. It can be understood that, a thickness of the second insulation adhesive 212 is specifically selected according to a use requirement. For example, the thickness of the second insulation adhesive 212 is any value of 5 µm, 5.5 µm, 6 µm, 6.5 µm, 7 µm, 7.5 µm, 8 µm, 8.5 µm, 9 µm, 9.5 µm, and 10 µm.

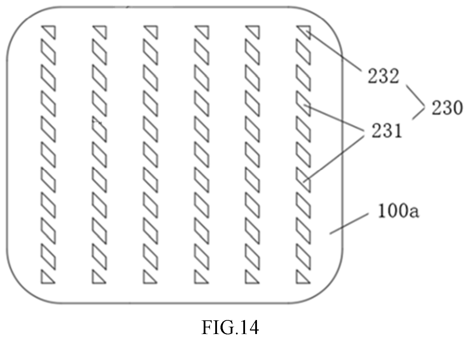

The following describes the structure of the solar cell in a sixth group of embodiments of the first aspect of the present application with reference to FIG. 14.

In this group of embodiments, the solar cell is a back contact solar cell; the electrode includes a plurality of support grid lines; the isolation member includes a plurality of isolation protrusions. For a back contact solar cell according to an embodiment of the present application, refer to FIG. 14. FIG. 14 is a schematic structural diagram of a light receiving surface of the back contact solar cell according to this embodiment of the present application. The back contact solar cell includes a solar cell body 100a, a plurality of support grid lines 330, and a plurality of isolation protrusions 230; the support grid lines 330 are provided on the back surface of the solar cell body 100a; and the isolation protrusion 230 is provided on the light receiving surface of the solar cell body 100a and protrudes from the light receiving surface of the solar cell body 100a, and an arrangement direction of the isolation protrusion 230 is parallel to an extension direction of the support grid line 330.

In some examples, at least part of the plurality of support grid lines 330 overlaps with projections of the plurality of isolation protrusions 230 on the back surface of the solar cell body 100a. It should be noted that, the foregoing overlapping means that there is an overlapping part.

In some embodiments, in a direction away from the solar cell body 100a, the support grid line 330 is the highest grid line in the back contact solar cell. For example, the back contact solar cell includes a busbar and a finger. A height of the busbar is greater than a height of the finger. In this case, the busbar is the support grid line 330. For example, the back contact solar cell includes a busbar and a finger. A height of the busbar is less than a height of the finger. In this case, the finger is the support grid line 330. For another example, the back contact solar cell has no busbar, and includes only a plurality of fingers. A finger having a largest height among the plurality of fingers is the support grid line 330.

According to the back contact solar cell in this embodiment of the present application, when a plurality of back contact solar cells is stacked in a transfer process of the back contact solar cells, a back surface of one back contact solar cell is in contact with a light receiving surface of another back contact solar cell. The light receiving surface of the solar cell body 100a is provided with the isolation protrusion 230 protruding from the light receiving surface of the solar cell body 100a, and an arrangement direction of the isolation protrusion 230 is parallel to an extension direction of the support grid line 330; the plurality of isolation protrusions 230 have a projection on the back surface of the solar cell body 100a, and at least part of the plurality of support grid lines 330 overlap with the projection. Therefore, when isolation protrusions 230 on one back contact solar cell and support grid lines 330 on another back contact solar cell are in a same direction, support grid lines 330 is in contact with corresponding isolation protrusions 230, or some support grid lines 330 are in contact with corresponding isolation protrusions 230, and there is a gap between the remaining support grid lines 330 and the light receiving surface of the solar cell body 100a; and when isolation protrusions 230 on one back contact solar cell intersect with support grid lines 330 on another back contact solar cell, the plurality of support grid lines 330 and the plurality of isolation protrusions 230 are arranged in a criss-cross manner and have intersecting parts in contact with each other, and there is a gap between a part where the support grid lines 330 and the isolation protrusions 230 are not in contact with each other and the light receiving surface of the solar cell body 100a. Therefore, the support grid line 330 does not contact the light receiving surface of the solar cell body, and the support grid line 330 does not scratch a light receiving surface of an adjacent solar cell body 100a, thereby effectively reducing the possibility of scratching the light receiving surface during transfer of back contact solar cells.

In an embodiment, referring to FIG. 14, the isolation protrusion 230 includes a plurality of sub-isolation protrusions 231, and the sub-isolation protrusions 231 have a bump-shaped structure; and a plurality of sub-isolation protrusions 231 in any isolation protrusion 230 is arranged at intervals.

In an embodiment, the isolation protrusion 230 has a long strip-shaped structure. The isolation protrusion 230 of the long strip-shaped structure is provided corresponding to the support grid line 330. When a plurality of back contact solar cells is stacked, the isolation protrusion 230 of the long strip-shaped structure may provide a relatively large and continuous isolation contact area, so that the light receiving surface of the back contact solar cell and the back surface of the back contact solar cell have a more stable isolation effect.

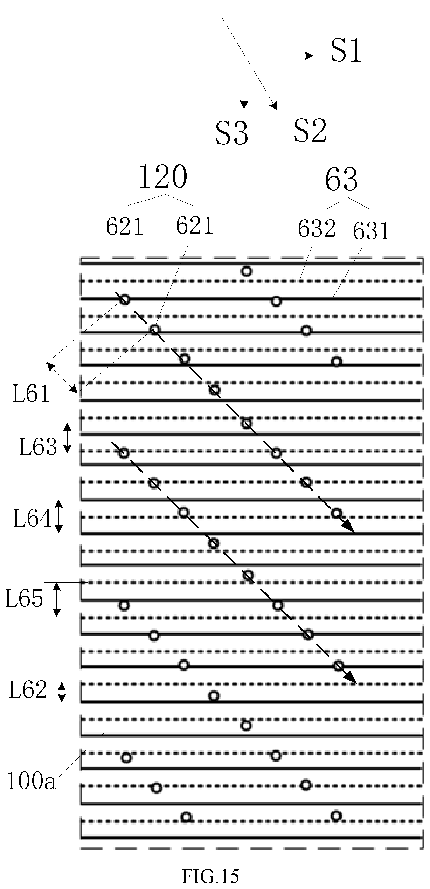

The following describes the structure of the solar cell in a seventh group of embodiments of the first aspect of the present application with reference to FIG. 15 to FIG. 18.

In this group of embodiments, the solar cell includes: a solar cell body 100a, including a first surface and a second surface that are opposite, the back surface is a first surface, and the light receiving surface is a second surface; As shown in FIG. 15, the electrode includes a plurality of fingers 63 provided on the first surface of the solar cell body 100a; the plurality of isolation members 120 are provided on the first surface and/or the second surface of the solar cell body 100a, and an extension direction of the plurality of isolation members 120 is intersected with an extension direction of the plurality of fingers 63; and the plurality of isolation members 120 includes a plurality of isolation bumps 621 arranged along the extension direction of the isolation member 120.

It should be noted that, in this embodiment of the present application, a plurality of isolation bumps 621 that is relatively close to each other and that is continuously provided in a row forms an isolation member 120. As shown in FIG. 15, a plurality of isolation bumps 621 stringed by a dashed arrow line are combined to form an isolation member 120. That is, FIG. 15 shows five isolation members 120.

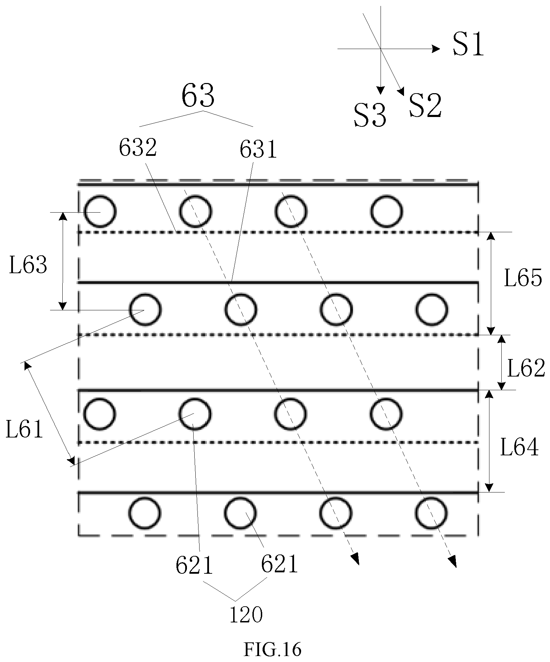

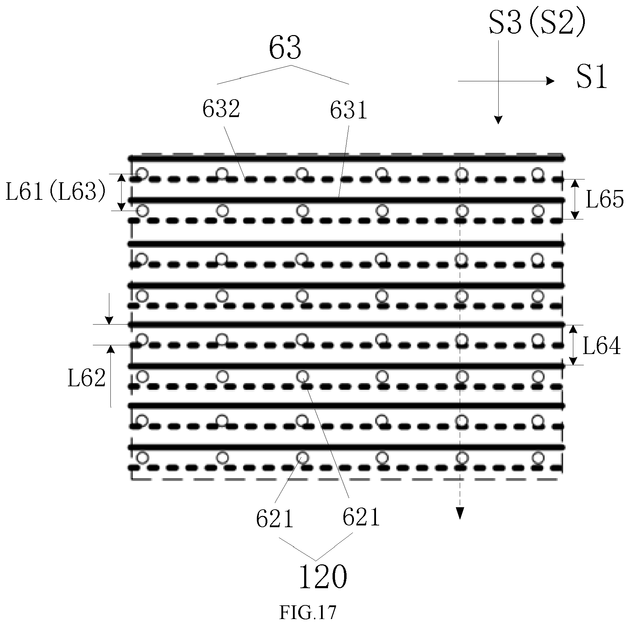

As shown in FIG. 15 and FIG. 16, an extension direction of the finger 63 is parallel to a direction S1, an extension direction of the isolation member 120 is parallel to a direction S2, the extension direction of the isolation member 120 may be non-perpendicular to the extension direction of the finger 63, a plurality of isolation members 120 are arranged at intervals along a direction S3 perpendicular to the finger 63, and the direction S2 is intersected with the direction S3. As shown in FIG. 17, an extension direction of the isolation member 120 may be perpendicular to an extension direction of the finger 63, and a direction S2 is the same as a direction S3.

In some examples, a distance between two adjacent isolation bumps 621 of a same isolation member 120 in the extension direction of the isolation member 120 is greater than a distance between two adjacent fingers 63.

In this embodiment of the present application, the finger 63 is provided on the first surface of the solar cell body 100a, and the isolation member 120 is provided on the first surface and/or the second surface of the solar cell body 100a. In this way, in a process of stacking and transferring solar cells, the isolation member 120 may exist between two adjacent solar cell bodies 100a, to perform a function of isolation and protection, to prevent a finger, a busbar, a terminal line, a pad, or the like on one solar cell from scratching a second surface of another solar cell. Based on the protection function of the isolation member 120, because the isolation member 120 includes a plurality of isolation bumps 621 along an extension direction of the isolation member, and a distance between two adjacent isolation bumps 621 of the same isolation member 120 in the extension direction of the isolation member 120 is greater than a distance between two adjacent fingers 63, the isolation bumps 621 are provided relatively sparsely. In this way, not only manufacturing costs of the isolation member 120 can be saved, but also a disposition quantity of isolation bumps 621 is reduced, so that blocking can be reduced, and a light absorption rate of the solar cell body 100a can be improved.

The busbar, the finger 63, the terminal line, and the pad are all provided on the first surface of the solar cell body 100a. In addition, the finger 63 may be a positive grid line or a negative grid line.

Specifically, the isolation member 120 may be provided on the first surface of the solar cell body 100a, the isolation member 120 may be provided on the second surface of the solar cell body 100a, or the isolation member 120 may be provided on each of the first surface and the second surface of the solar cell body 100a. In this embodiment of the present application, the finger 63 and the isolation member 120 may be provided on a same face of the solar cell body 100a, or the finger 63 and the isolation member 120 may be respectively provided on two opposite faces of the solar cell body 100a.

In some embodiments, an extension direction of the isolation member 120 may intersect with an extension direction of the finger 63, to ensure that at least part of the isolation members 120 are always capable of performing a function of isolating and protecting a light receiving surface of an adjacent solar cell when solar cells are stacked.

It can be understood that, as shown in FIG. 17, the extension direction of the isolation member 120 may be perpendicular to the extension direction of the finger 63. Alternatively, as shown in FIG. 16, an acute angle or an obtuse angle is set between the extension direction of the isolation member 120 and the extension direction of the finger 63.

Specifically, as shown in FIG. 15, FIG. 16, and FIG. 17, a column of isolation bumps 621 stringed by a dashed arrow line are combined to form an isolation member 120. A plurality of isolation members 120 may be arranged at intervals along the extension direction of the finger 63.

In some embodiments, extension directions of all the isolation members 120 may be the same.

In some other embodiments, extension directions of the plurality of isolation members 120 may not be completely the same.

Specifically, the isolation member 120 may include a plurality of isolation bumps 621 arranged at intervals along an extension direction of the isolation member, which can reduce the coverage ratio of the isolation member 120 on the first surface and/or the second surface, and can reduce manufacturing costs of the isolation member 120. In addition, the coverage ratio on the light receiving surface of the solar cell can be reduced, and blocking on the light receiving surface of the solar cell can be further reduced, thereby improving the optical-to-electrical conversion efficiency of the photovoltaic module.

In some examples, a distance between two adjacent isolation bumps 621 of a same isolation member 120 in the extension direction of the isolation member 120 is greater than a distance between two adjacent fingers 63. Because the isolation bumps 621 are relatively sparsely provided, it is convenient to further reduce the coverage ratio of the isolation bumps 621 on the first surface and/or the second surface.

For example, as shown in FIG. 15 to FIG. 17, the finger 63 extends along the direction S1, and the isolation member 120 extends along the direction S2. A distance between two adjacent isolation bumps 621 of a same isolation member 120 in the direction S2 is L61, and a distance between two adjacent fingers 63 is L62, where L61>L62.

It should be noted that, in the present application, a distance between two adjacent fingers 63 is a width of a gap between the two adjacent fingers 63 in the direction S3, that is, a minimum distance between the two adjacent finger 63 in the direction S3. A distance between two adjacent isolation bumps 621 may be a distance between centers of the two adjacent isolation bumps 621, that is, a distance between circle centers of the two adjacent isolation bumps 621, or may be a width of a gap between the two adjacent isolation bumps 621, that is, a minimum distance between the two adjacent isolation bumps 621.

For example, a distance between two adjacent isolation bumps 621 in a same isolation member 120 in an extension direction of the isolation member 120 may be a distance between circle centers of the two adjacent isolation bumps 621 in the same isolation member 120 in the extension direction of the isolation member 120, or a minimum distance between the two adjacent isolation bumps 621 in the same isolation member 120 in the extension direction of the isolation member 120.

A distance between two adjacent isolation bumps 621 in a same isolation member 120 in a direction perpendicular to the finger 63 may be a distance between circle centers of the two adjacent isolation bumps 621 in the same isolation member 120 in the direction perpendicular to the finger 63, or a minimum distance between the two adjacent isolation bumps 621 in the same isolation member 120 in the direction perpendicular to the finger 63.

In some examples, the isolation bump 621 may be a transparent member having a light transmission feature, whose light transmission rate may be greater than 80%, or the isolation bump 621 may be a light shielding member having a light shielding property.

In this embodiment of the present application, the finger 63 may be regularly arranged on the first surface. The isolation members 120 may be regularly arranged on the first surface and/or the second surface, or the isolation members 120 may be regularly arranged in at least one local region on the first surface and/or the second surface. No isolation member 120 may be provided in other regions, or isolation members 120 in other regions may be irregularly arranged. Specifically, as shown in FIG. 15 to FIG. 17, only a local region on the first surface and/or the second surface is shown, to which reference may be made for the arrangement of the isolation member 120 and the finger 63. Details are not described herein again in the present application.

In some embodiments of the present application, a distance between two adjacent isolation bumps 621 in a same isolation member 120 in a direction perpendicular to the finger 63 is greater than a distance between two adjacent fingers 63, so that sparsity of the isolation bumps 621 can be improved while ensuring isolation and protection of the isolation member 120 on the light receiving surface of the solar cell, to reduce manufacturing costs of the isolation bumps 621 and improve a light absorption rate of the solar cell.

Specifically, as shown in FIG. 15 to FIG. 17, a distance between two adjacent isolation bumps 621 of a same isolation member 120 in the direction S3 perpendicular to the finger 63 is L63, and a distance between two adjacent fingers 63 is L62, where L63>L62.

In some other embodiments of the present application, a distance between two adjacent isolation bumps 621 in a same isolation member 120 in a direction perpendicular to the finger 63 may alternatively be less than a distance between two adjacent fingers 63, to more effectively prevent a finger 63, a busbar, a terminal line, a pad, or the like of one solar cell from scratching the other solar cell stacked with the solar cell.

In some embodiments, the plurality of fingers 63 include first fingers 631 and second fingers 632 that are alternately arranged along a direction perpendicular to the plurality of fingers 63. One of the first finger 631 and the second finger 632 is a positive grid line, and the other is a negative grid line.

In an embodiment, a distance between two adjacent isolation bumps 621 of a same isolation member 120 in the extension direction of the isolation member 120 is greater than a distance between two adjacent first fingers 631. In this way, a distance between two adjacent isolation bumps 621 of a same isolation member 120 in the extension direction of the isolation member 120 is greater than a distance between fingers 63 of the same polarity, so that sparsity of the isolation bumps 621 can be further increased, a quantity of the isolation bumps 621 is reduced, manufacturing costs of the isolation bumps 621 and the coverage ratio of the isolation bumps 621 on the solar cell body 100a are reduced, and a light absorption rate of the solar cell body 100a is improved.

Specifically, as shown in FIG. 17, a distance between two adjacent first fingers 631 is L64, where L61>L64.

In some other embodiments, a distance between two adjacent isolation bumps 621 of a same isolation member 120 in the extension direction of the isolation member 120 is less than a distance between two adjacent first fingers 631, to more effectively prevent a finger 63, a busbar, a terminal line, a pad, or the like of one solar cell from scratching the other solar cell stacked with the solar cell.

In an embodiment, a distance between two adjacent isolation bumps 621 of a same isolation member 120 in the extension direction of the isolation member 120 is greater than a distance between two adjacent second fingers 632. In this way, a distance between two adjacent isolation bumps 621 of a same isolation member 120 in the extension direction of the isolation member 120 is greater than a distance between fingers 63 of the same polarity, so that the sparsity of the isolation bumps 621 can be further increased, and manufacturing costs of the isolation bumps 621 can be reduced.

Specifically, as shown in FIG. 17, a distance between two adjacent second fingers 632 is L65, where L61>L65.

In this embodiment of the present application, a distance between two adjacent isolation bumps 621 of a same isolation member 120 in the extension direction of the isolation member 120 may be greater than a distance between two adjacent first fingers 631; or a distance between two adjacent isolation bumps 621 of a same isolation member 120 in the extension direction of the isolation member 120 may be greater than a distance between two adjacent second fingers 632; or a distance between two adjacent isolation bumps 621 of a same isolation member 120 in the extension direction of the isolation member 120 may be greater than both a distance between two adjacent first fingers 631 and a distance between two adjacent second fingers 632.

In some other embodiments, a distance between two adjacent isolation bumps 621 of a same isolation member 120 in the extension direction of the isolation member 120 is less than a distance between two adjacent second fingers 632, to more effectively prevent a finger 63, a busbar, a terminal line, a pad, or the like of one solar cell from scratching the other solar cell stacked with the solar cell.

In an embodiment, a distance between the two adjacent isolation bumps 621 of the same isolation member 120 in a direction perpendicular to the finger 63 is greater than the distance between the two adjacent first fingers 631. In this way, a distance between the two adjacent isolation bumps 621 of the same isolation member 120 in a direction perpendicular to the finger 63 is greater than the distance between the fingers 63 of the same polarity, so that the sparsity of the isolation bumps 621 can be further increased, a quantity of the isolation bumps 621 is reduced, manufacturing costs of the isolation bumps 621 can be reduced, and a light absorption rate of the solar cell is improved.

Specifically, as shown in FIG. 15 to FIG. 17, a distance between two adjacent isolation bumps 621 of a same isolation member 120 in the direction S3 perpendicular to the finger 63 is L63, and a distance between two adjacent first fingers 631 is L64, where L63>L64.

In an embodiment, a distance between the two adjacent isolation bumps 621 of the same isolation member 120 in a direction perpendicular to the finger 63 is greater than the distance between the two adjacent second fingers 632. In this way, a distance between the two adjacent isolation bumps 621 of the same isolation member 120 in a direction perpendicular to the finger 63 is greater than the distance between the fingers 63 of the same polarity, so that the sparsity of the isolation bumps 621 can be further increased, manufacturing costs of the isolation bumps 621 can be reduced, and a light absorption rate of the solar cell is improved.

Specifically, as shown in FIG. 15 to FIG. 17, a distance between two adjacent isolation bumps 621 of a same isolation member 120 in the direction S3 perpendicular to the finger 63 is L63, and a distance between two adjacent second fingers 632 is L65, where L63>L65.

In this embodiment of the present application, a distance between the two adjacent isolation bumps 621 of the same isolation member 120 in a direction perpendicular to the finger 63 may be greater than the distance between the two adjacent first fingers 631; or a distance between the two adjacent isolation bumps 621 of the same isolation member 120 in a direction perpendicular to the finger 63 may be greater than the distance between the two adjacent second fingers 632; or a distance between the two adjacent isolation bumps 621 of the same isolation member 120 in a direction perpendicular to the finger 63 may be greater than both a distance between two adjacent first fingers 631 and a distance between two adjacent second fingers 632.

In some other embodiments of the present application, a distance between the two adjacent isolation bumps 621 of the same isolation member 120 in a direction perpendicular to the finger 63 may alternatively be less than the distance between the two adjacent first fingers 631, and/or a distance between the two adjacent isolation bumps 621 of the same isolation member 120 in a direction perpendicular to the finger 63 may alternatively be less than the distance between the two adjacent second fingers 632, so that a distance between the two adjacent isolation bumps 621 of the same isolation member 120 in a direction perpendicular to the finger 63 is less than the distance between the two fingers 63 of the same polarity, to more effectively prevent a finger, a busbar, a terminal line, a pad, or the like of one solar cell from scratching the other solar cell stacked with the solar cell.

In some examples, the isolation member 120 is provided on the second surface, and a projection of at least one isolation bump 621 on the first surface has an overlapping region with the finger 63. Through the technical solution, when a plurality of solar cells is stacked, it is easy to make at least one isolation bump 621 on one solar cell come into contact with a finger 63 on another solar cell. In this way, a finger, a busbar, the pad, a terminal line, or the like can be effectively prevented from scratching the surface of the solar cell body 100a. Certainly, in some other examples, alternatively, there may be no overlapping region between the projection of the isolation bump 621 on the first surface and the finger 63. In this case, a height and a quantity of isolation bumps 621, an arrangement manner of the plurality of isolation bumps 621, a stack manner of the plurality of solar cells, or the like may be set, so that the isolation bumps 621 may play a role in preventing a finger, a busbar, a pad, a terminal line, or the like from scratching the surface of the solar cell body 100a.

In some embodiments, the isolation member 120 may be arranged on the first surface, and the isolation bump 621 may be arranged at an interval with the finger 63, to avoid a case that the isolation bump 621 affects the electrical connection between the busbar or an interconnection member and the finger 63. The interconnection member may be a welding strip, an electrically conductive tape, or the like.

In some embodiments, the solar cell includes a finger and a pad. A height of the isolation bumps 621 is greater than or equal to a height of the higher one of the finger 63 and the pad. In this way, a finger and a pad of one solar cell can be prevented from coming into contact with a light receiving surface of the other solar cell to be stacked, so as to ensure that the isolation bumps 621 can play a role of isolation and protection, and prevent a finger and a pad of one solar cell from scratching a light receiving surface of the other solar cell.

Specifically, the pad is used to electrically connect to the interconnection member, so as to connect different solar cells.

In some other embodiments, the solar cell includes a finger 63, a pad, and a busbar. The busbar is electrically connected to a plurality of fingers 63, and is configured to converge collected currents. The pad is electrically connected to the busbar. A height of the isolation bumps 621 is greater than or equal to a height of the higher one of the pad, the finger 63, and the busbar. In this way, a pad, a finger 63, and a busbar of one solar cell can be prevented from coming into contact with a light receiving surface of the other solar cell to be stacked, so as to ensure that the isolation bumps 621 can play a role of isolation and protection, and prevent a pad, a finger 63, and a busbar of one solar cell from scratching a light receiving surface of the other solar cell.

In some other embodiments, the solar cell includes a finger, a pad, and a terminal line, each finger of a plurality of fingers located at the edge of the solar cell body 100a includes a plurality of finger segments sequentially arranged along an extension direction of the finger, and the terminal line is electrically connected to the plurality of finger segments located at the edge of the solar cell body 100a. The plurality of fingers located in the middle region of the solar cell body is continuously provided, the pad is provided on the terminal line and the continuous fingers, and the height of the isolation bump 621 is greater than the height of the higher one of the pad, the finger 63, and the terminal line. In this way, a finger, a pad, and a terminal line of one solar cell can be prevented from coming into contact with a light receiving surface of the other solar cell to be stacked, so as to ensure that the isolation bumps 621 can play a role of isolation and protection, and prevent a finger, a pad, and a terminal line of one solar cell from scratching a light receiving surface of the other solar cell.

Specifically, the terminal line is used to connect to fingers 63 of a same polarity, and the terminal line may include a first terminal line connecting a plurality of first sub-fingers 6311, and a second terminal line connecting a plurality of second sub-fingers 6321.

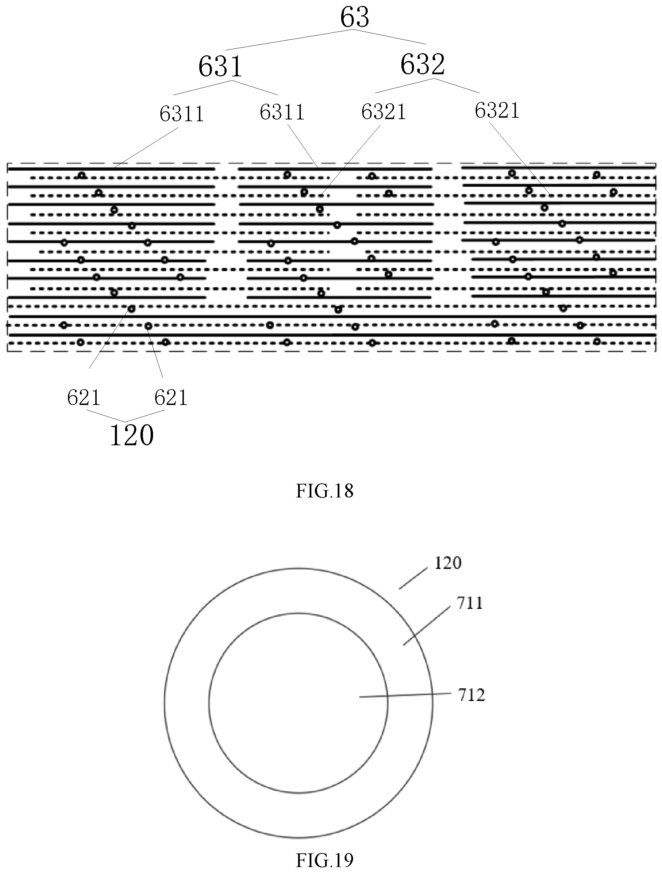

In some embodiments of the present application, as shown in FIG. 18, the plurality of fingers 63 include first fingers 631 and second fingers 632 that are alternately arranged along a direction perpendicular to the plurality of fingers 63. A part of the first finger 631 located on at least one side edge of the solar cell body 100a includes a plurality of first sub-fingers 6311 arranged at intervals, and a part of the second finger 632 includes a plurality of second sub-fingers 6321 arranged at intervals. The first sub-fingers 6311 and the second sub-fingers 6321 are arranged in a staggered manner. The plurality of first sub-fingers 6311 arranged along a direction perpendicular to the finger 63 are electrically connected together by using the first terminal line, and the plurality of second sub-fingers 6321 arranged along a direction perpendicular to the finger 63 are electrically connected together by using the second terminal line.

In this embodiment of the present application, the plurality of first sub-fingers 6311 are electrically connected together by using the first terminal line. In this way, by electrically connecting to the first terminal line, the interconnection member can electrically connect the plurality of first sub-fingers 6311. Further, the interconnection member may be set at a particular distance from the edge of the solar cell body 100a, to prevent damage to the edge of the solar cell body 100a caused when the interconnection member is electrically connected to the first finger 631 located at the edge. The plurality of second sub-fingers 6321 are electrically connected together by using the second terminal line. In this way, by electrically connecting to the second terminal line, the interconnection member can electrically connect the plurality of second sub-fingers 6321. Further, the interconnection member may be set at a particular distance from the edge of the solar cell body 100a, to prevent damage to the edge of the solar cell body 100a caused when the interconnection member is electrically connected to the second finger 632 located at the edge.

It should be noted that, as shown in FIG. 18, for ease of distinction, a solid line and a dashed line are used to respectively represent the first finger 631 and the second finger 632. In actual application, each of the first finger 631 and the second finger 632 has a solid-line rather than dashed structure.

Specifically, in some examples, as shown in FIG. 18, some of the first fingers 631 may be continuous, some of the first fingers 631 may be segmented, some of the second fingers 632 may be continuous, and some of the second fingers 632 may be segmented. In some other embodiments, alternatively, each of the first fingers 631 and the second fingers 632 may be continuous.

In the present application, it is considered that during design of the isolation bumps, if a dimension of the isolation bumps 621 is excessively small, implementation is difficult in a process; and if a dimension of the isolation bumps 621 is excessively large, light shielding is too much, which is not beneficial to light absorption of the solar cell body 100a. Therefore, in some embodiments, a maximum dimension of the isolation bump 621 is d. When a projection of the isolation bump 621 on the first surface is a circle or an approximate circle, the maximum dimension is a diameter of the isolation bump 621, where 50 µm ≤ d ≤ 2000 µm. In this embodiment of the present application, the diameter of the isolation bump 621 is limited, so that the difficulty in manufacturing the isolation member 120 is low, and a light absorbing capability of the solar cell body 100a can be ensured.

For example, the diameter of the isolation bump 621 may be 50 µm, 255 µm, 380 µm, 500 µm, 850 µm, 1150 µm, 1500 µm, 1860 µm, 1900 µm, 2000 µm, or the like.

As described above, a height h of the isolation member 120 ranges from 2 µm to 80 µm. In some examples, a height of the isolation bump ranges from 3 µm to 80 µm.

As described above, in some embodiments, the coverage ratio of the isolation bumps 621 on the first surface and/or the second surface is designed as S81, where 0.5% ≤ S81 ≤ 10%, to effectively ensure an effect of preventing the surface of the solar cell body 100a from being scratched by the isolation bumps 621, and ensure a light absorbing capability of the solar cell body 100a.

The following describes the structure of the solar cell in an eighth group of embodiments of the first aspect of the present application with reference to FIG. 19 to FIG. 21.

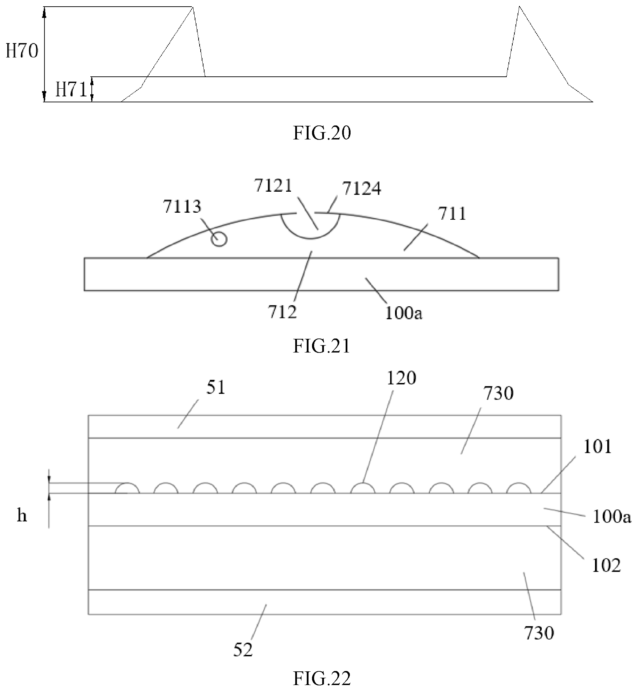

In this group of embodiments, the solar cell includes a solar cell body 100a. At least one face of the solar cell body 100a is provided with a plurality of isolation members 120 arranged at intervals. As shown in FIG. 19, the isolation member 120 includes a central portion 712 and a peripheral portion 711 provided around the central portion 712. As shown in FIG. 21, a side surface of the central portion 712 away from the solar cell body 100a has a recess 7121. As shown in FIG. 20, in the direction perpendicular to the solar cell body 100a, a minimum height of the central portion 712 is H71, and a maximum height of the isolation member 120 is H70, satisfying: $0 < H 71 \leq \frac{2}{3} H 70$.

According to the solar cell of this embodiment of the present application, because the recess 7121 is provided in the central portion 712, and the minimum height H71 of the central portion 712 and the maximum height H70 of the isolation member 120 satisfy the foregoing relationship, when the isolation member 120 is in contact with the surface of the solar cell of the upper photovoltaic module, the pressing action of an adjacent solar cell causes deformation of the isolation member 120, to evacuate air in the recess 7121. The isolation member 120 plays a role in negative-pressure adsorption to adsorb and fix two adjacent solar cells together, thereby avoiding a case that an inclination situation occurs in a stack and transfer process of the plurality of solar cells, and further avoiding a case that the isolation member 120 is moved relative to an adjacent solar cell, to scratch the solar cell or cause a hidden crack. Certainly, it can be understood that, the recess does not hinder isolation of the solar cells during subsequent lamination. In addition, when the photovoltaic module is in use, the recess can increase the overall light transmission rate of the isolation member, so that more light is shed on the solar cell, thereby increasing the power generation efficiency of the solar cell. Further, the disposition of the recess 7121 may further save a quantity of glue materials, and save production costs of the solar cell.

It can be understood that, a relationship between the minimum height H71 of the central portion 712 and the maximum height H70 of the isolation member 120 may be set according to a use requirement. For example, H71 is one of ${\frac{1}{12}}^{} \text{H70} {\text{,}}^{\frac{1}{6}} \text{H70} {\text{,}}^{\frac{1}{4}} \text{H70} {\text{,}}^{\frac{1}{3}} \text{H70} {\text{,}}^{\frac{5}{12}} \text{H70} {\text{,}}^{\frac{1}{2}} \text{H70} {\text{,}}^{\frac{7}{12}} \text{H70}$ , and $\frac{2}{3} H 70$, and a plurality of ratios among the foregoing ratios. It can be understood that, if $H 71 > \frac{2}{3} H 70$, an excessively small recess affects the overall light transmission rate of the isolation member, and an excessively small formed negative-pressure cavity affects an effect of preventing movement or inclination of the solar cell. If H71 = 0, that is, there is no central portion, an isolating effect and a stabilizing effect of the isolation member cannot be ensured by relying on only the peripheral portion.

In some embodiments, the isolation member 120 is provided on the light receiving surface 101. The light receiving surface 101 has a pyramid-type micro structure. The minimum height H71 of the central portion 712 is a vertical distance from a lowest point of the recess 7121 to a highest point of the pyramid-type micro structure. The maximum height H70 of the isolation member 120 is a vertical distance from a highest point of the isolation member 120 to the highest point of the pyramid-type micro structure. In this case, without affecting the effect of the pyramid-type micro structure, the isolation member 120 improves the light trapping property and the light absorbing efficiency, so as to use more solar energy; and prevent the pyramid-type micro structure from being scratched when a plurality of solar cells is stacked, thereby ensuring the performance of the solar cells.

Referring to FIG. 21, the isolation member 120 further includes a covering layer 7124, and the covering layer 7124 partially or completely covers the recess 7121. In this embodiment of the present application, disposition of the covering layer 7124 can avoid a case that the packaging adhesive film 730 fills the recess 7121 when the isolation member 120 is connected to the packaging adhesive film 730, to affect a function of the recess 7121, so that the light trapping property of the isolation member 120 is ensured. With reference to the foregoing embodiment, when the recess 7121 has a relatively small projection dimension, effects such as insufficient increase in the light transmission rate and reduction in the adsorption stability that are caused due to a relatively small recess are compensated by using the covering layer 7124.

In some embodiments, as shown in FIG. 21, at least one cavity 7113 is provided inside the peripheral portion 711. Disposition of the cavity 7113 may enable incident light to be reflected a plurality of times at the isolation member 120, lengthen a path length of the light inside the photovoltaic module, and increase the light trapping property to improve light absorbing efficiency, so as to use more solar energy.

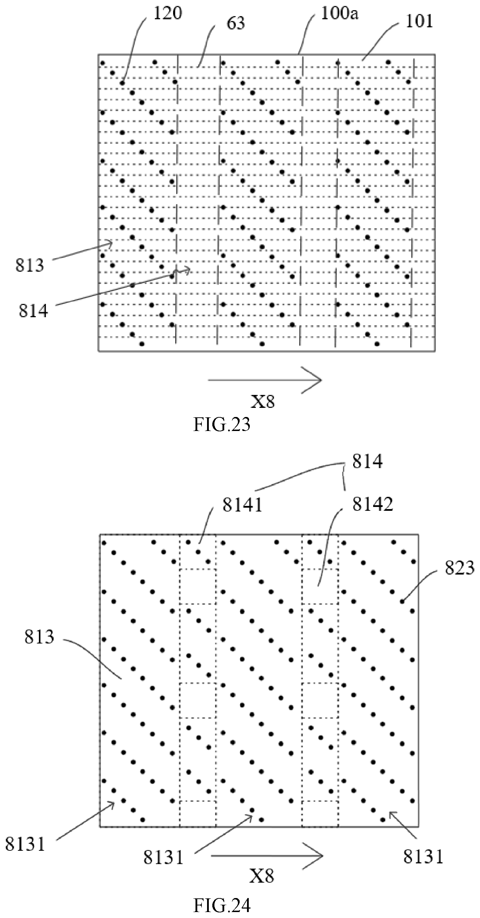

The following describes the structure of the solar cell in a ninth group of embodiments of the first aspect of the present application with reference to FIG. 23 to FIG. 26.

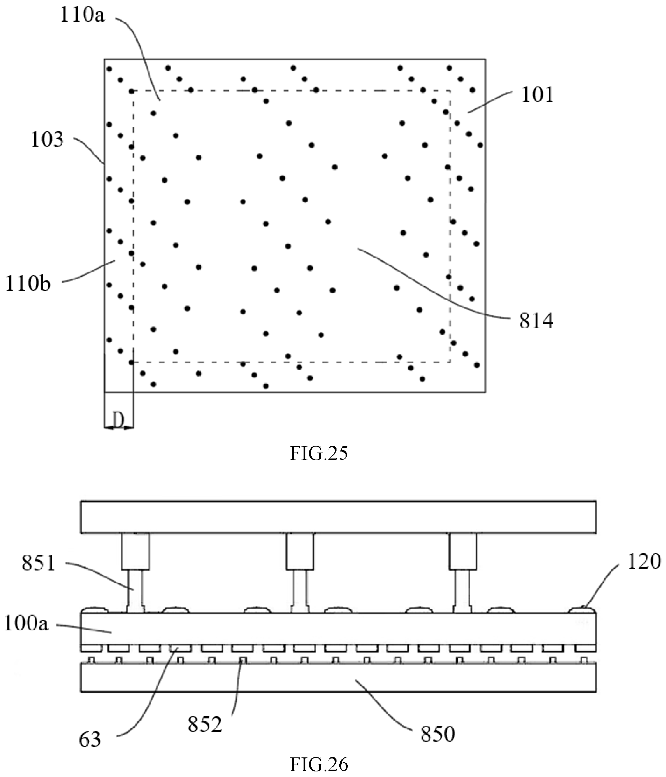

When a performance test is performed on a solar cell, a test probe of a test apparatus is in contact with a test point such as a finger or a pad of the solar cell in some tests. For example, referring to FIG. 26, when an IV test, that is, a current-voltage characteristic test, is performed, a test probe 852 is in contact with a test point such as a pad. To ensure that the test probe 852 is in sufficient and effective contact with the test point, a pressing member 851 is further used to press against an opposite surface of a surface of a solar cell provided with a finger 63. The inventor finds that when isolation members 120 are manufactured, heights of the plurality of isolation members 120 are different. In this way, if the pressing member 851 is in contact with the isolation member 120, during a test, pressures on test points on a back face of the solar cell are different. Consequently, contact degrees between the test probe 852 and the test points on the back surface of the solar cell are different. A test difference occurs during the test, thereby affecting accuracy of a test result. Referring to FIG. 23, the solar cell disclosed in this embodiment of the present application can resolve the foregoing problem.

In this group of embodiments, a solar cell is disclosed. Referring to FIG. 23, the solar cell includes a solar cell body 100a, a plurality of isolation members 120, and a plurality of fingers 63, the solar cell body 100a includes a light receiving surface and a back surface that are opposite, and the light receiving surface includes a fifth region 813 and a plurality of sixth regions 814. The plurality of isolation members 120 is provided on the light receiving surface of the solar cell body 100a.

In some embodiments, a density of a part of the plurality of isolation members 120 located in the fifth region 813 is greater than a density of a part of the plurality of isolation members 120 located in each of the plurality of sixth regions 814; the plurality of fingers 63 are provided on the back surface 102 of the solar cell body 100a, and the plurality of sixth regions 814 are arranged along an extension direction of the plurality of fingers 63 (for the extension direction, refer to an arrow X8 shown in FIG. 23); and an extension direction of each of the plurality of sixth regions 814 is perpendicular to the plurality of fingers 63.

On the light receiving surface 101, the density of the isolation members 120 located in the fifth region 813 is greater than the density of the isolation members 120 located in the sixth region 814, the density of the isolation members 120 in the sixth region 814 is relatively small, and the sixth region 814 may be used as a region that is in contact with the pressing member 851 when a performance test is performed on the solar cell. In this way, pressing against the isolation member 120 or coming into contact with the isolation member 120 by the pressing member 851 can be reduced or avoided. In this way, forces by which the pressing member 851 presses the solar cell downward are relatively even. Pressures on test points on the back surface 102 of the solar cell are the same or approximately the same. The test probe 852 and the test points are in the same contact degree and can be sufficiently and effectively brought into contact, so that accuracy of a test result of the solar cell is high.

The test points include the finger 63, the pad, and the like.

The density of the isolation members 120 refers to a covering area of the isolation members 120 per unit area.

In some embodiments, referring to FIG. 23, no isolation member 120 is provided in the sixth region 814. In this way, when a test is performed on the solar cell, the solar cell is adapted to butt against a plurality of pressing members 851. For example, the sixth region 814 is adapted to butt against a plurality of cylindrical pressing members, adapted to butt against a short strip-shaped pressing member, or adapted to butt against a long strip-shaped pressing member. In addition, in a process in which the pressing member 851 butts against the sixth region 814, it is ensured that the pressing member 851 definitely does not contact the isolation member 120, thereby avoiding a case that a test difference occurs during a test due to different contact degrees between the test probe 852 and test points on the back surface 102 of the solar cell because the pressing member 851 presses against the isolation member 120 or contacts the isolation member 120. Therefore, it is further ensured that the solar cell in this embodiment of the present application has an advantage of high accuracy of a test result. Perpendicular to the extension direction of the finger 63, a length of the contact between the short strip-shaped pressing member and the sixth region 814 is less than a length of the light receiving surface 101, and a length of the contact between the long strip-shaped pressing member and the sixth region 814 is equal to the length of the light receiving surface 101.

In some embodiments, referring to FIG. 24, the sixth region 814 includes first sub-regions 8141 and second sub-regions 8142 that are arranged along the direction perpendicular to the finger 63. An isolation member 120 is provided in the first sub-region 8141, and no isolation member 120 is provided in the second sub-region 8142.

In this embodiment of the present application, when a test is performed on a solar cell, the pressing member 851 presses against the second sub-region 8142, so that pressing against the isolation member 120 or coming into contact with the isolation member 120 by the pressing member 851 can be avoided. In this way, forces by which the pressing member 851 presses the solar cell downward are relatively even. Pressures on test points on the back surface 102 of the solar cell are the same or approximately the same. The test probe 852 and the test points are in the same contact degree and can be sufficiently and effectively brought into contact, so that accuracy of a test result of the solar cell is high. Disposition of the isolation member 120 on the first sub-region 8141 can improve an isolating and protecting effect, to avoid a case that the light receiving surface 101 is scratched by an adjacent solar cell to affect performance of the solar cell when a plurality of solar cells is stacked.

In some embodiments, referring to FIG. 24, perpendicular to the extension direction of the finger 63, the first sub-regions 8141 and the second sub-regions 8142 are alternately provided.

In some embodiments, referring to FIG. 24, the fifth region 813 includes a plurality of third sub-regions 8131, and the third sub-regions 8131 and the sixth regions 814 are alternately arranged along the extension direction of the finger 63. In this way, the third sub-region 8131 and the sixth region 814 are adjacent to each other along the extension direction of the finger 63. The isolation member 120 provided on the third sub-region 8131 can avoid, when a plurality of solar cells is stacked, a case that an adjacent solar cell scratches the third sub-region 8131 and the sixth region 814 to affect performance of the solar cell.

In the foregoing embodiment, if the sixth region 814 includes the first sub-regions 8141 and the second sub-regions 8142, when the third sub-regions 8131 and the first sub-regions 8141 are alternately arranged along the extension direction of the finger 63, because the third sub-regions 8131 and the first sub-regions 8141 are each provided with an isolation member 120, the isolation members 120 are connected to form an integral structure in the third sub-regions 8131 and the first sub-regions 8141. In some examples, the first sub-regions 8141 are provided on one side or two sides of the sixth region 814 along the direction perpendicular to the finger.

In some embodiments, referring to FIG. 25, the solar cell further includes a middle region 110a and an edge region 110b, and the middle region 110a is provided in the middle of the light receiving surface 101. The edge region 110b is provided at an edge of the light receiving surface, and is provided around the middle region 110a. A density of isolation members 120 located in the edge region 110b is greater than a density of isolation members 120 located in the middle region 110a.

In this embodiment of the present application, during a stacking process, a plurality of solar cells naturally descends and is aligned due to gravity. Therefore, an edge of the solar cell is most easily scratched. In this way, in the light receiving surface 101, the edge region 110b is located at an edge of the solar cell body 100a, and the density of the isolation members 120 located in the edge region 110b is relatively large. Based on satisfying a function of isolating and protecting the light receiving surface 101, the isolation member 120 enhances a function of protecting an edge region around the light receiving surface 101, so that an effect of isolating and protecting the solar cell is better.

In some embodiments, an extension direction of the isolation member 120 is parallel to or is intersected with an extension direction of the finger 63. When the extension direction of the plurality of isolation members 120 is intersected with the extension direction of the plurality of fingers 63, an included angle between the extension directions may be an acute angle, or may be a right angle. All the isolation members 120 can have a good isolating and protecting function.

The following describes the structure of the solar cell in a tenth group of embodiments of the first aspect of the present application with reference to FIG. 1, FIG. 27, and FIG. 28.

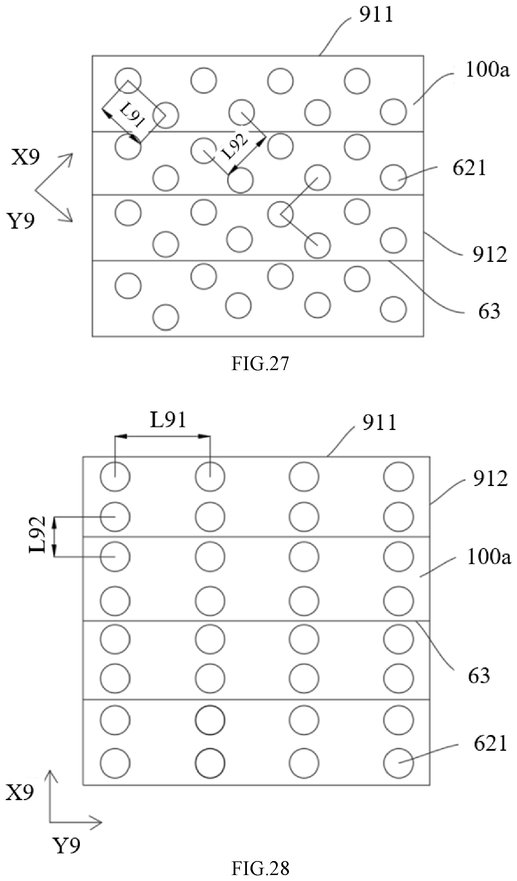

When the distance between the isolation bumps is excessively small, for example, when two adjacent isolation bumps are close to each other, material costs of the isolation bumps are increased. When the distance between the isolation bumps is excessively large, an isolation effect of the isolation bumps is poor. Therefore, it is difficult for disposition of the isolation bumps to consider both the isolation effect and the material costs of the isolation bumps. Referring to FIG. 27 and FIG. 28, an embodiment of the present application provides a solar cell, to resolve the foregoing technical problem.

In this group of embodiments, the isolation member includes isolation bumps 621. In a thickness direction of the solar cell body, the solar cell body includes a first surface and a second surface that are provided opposite to each other, and the isolation bumps 621 are provided on the first surface and/or the second surface of the solar cell body.

In some embodiments, referring to FIG. 27, the plurality of isolation bumps 621 is arranged into a plurality of rows along a fourth direction X9, and each of the plurality of rows of isolation bumps 621 includes a plurality of isolation bumps 621 arranged along a fifth direction Y9. When the plurality of isolation bumps 621 is designed, the following relation is satisfied: $0 < l < \sqrt[4]{3 ∗ {10}^{5} {mm}^{3} ∗ \frac{hn}{N 0.098}}$, where *l* is a larger one of a distance between two adjacent isolation bumps 621 along the fourth direction X9 and a distance between two adjacent isolation bumps 621 along the fifth direction Y9, h is a height of each of the plurality of isolation bumps 621, and n is an integer obtained by rounding off a ratio of a long side to a short side of the solar cell. It should be noted that, rounding off a ratio of a long side to a short side means that when a decimal part of the ratio after rounding off is greater than or equal to 0.5, a rounding-up manner may be used; or when a decimal part of the ratio after rounding off is less than 0.5, a rounding-down manner may be used, and N is a quantity of solar cells that are stacked.

In this embodiment of the present application, referring to FIG. 28, a distance between two adjacent isolation bumps 621 along the fourth direction X9 is L92, and a distance between two adjacent isolation bumps 621 along the fifth direction Y9 is L91. L92 and L91 are compared, and a larger one of L91 and L92 is the largest distance *l* between adjacent isolation bumps 621 along the fourth direction X9 or along the fifth direction Y9.

It should be noted that, in the following description, each "distance *l* between two adjacent isolation bumps 621" refers to a larger one of a distance between two adjacent isolation bumps 621 along the fourth direction X9 and a distance between two adjacent isolation bumps 621 along the fifth direction Y9.

When the light receiving surface of the solar cell body 100a is a polished surface, along a thickness direction of the solar cell body 100a, a distance between an end portion of the isolation bump 621 facing away from the solar cell body 100a and an interface at which the isolation bump 621 is in contact with the solar cell body 100a is a height h of the isolation bump 621. When the light receiving surface of the solar cell body 100a is a pyramid textured surface, along a thickness direction of the solar cell body 100a, a distance between an end portion of the isolation bump 621 facing away from the solar cell body 100a and an apex of a pyramid in an interface at which the isolation bump 621 is in contact with the solar cell body 100a is a height h of the isolation bump 621.

When a plurality of solar cells is stacked, each solar cell other than the top solar cell is bent due to a pressure from another solar cell. A higher height of the isolation bump 621 indicates that it is more difficult for a finger 63, a busbar, a pad, the terminal line, or the like of an upper solar cell to be in contact with a light receiving surface of a lower solar cell among two adjacent solar cells, and then it is not easier for the upper solar cell to scratch the light receiving surface of the lower solar cell. A distance between adjacent isolation bumps 621 affects a curvature of a solar cell. A larger distance between adjacent isolation bumps 621 indicates a larger curvature of the solar cell, and a larger curvature indicates that it is easier to scratch a light receiving surface of a solar cell adjacent to the solar cell. In addition, the weight of a solar cell also affects a pressure generated by the solar cell. When an entire solar cell has a fixed weight, a larger number of fragments obtained by dividing the entire solar cell indicates a smaller weight of a fragment obtained by dividing the solar cell and a smaller pressure generated by the solar cell. It can be understood that, n is an integer obtained by rounding off a ratio of a long side to a short side of the solar cell. When n is 1, the solar cell is an entire solar cell, and is not divided. When n is 2, the solar cell is divided into two fragments of solar cells, and when n is 3, the solar cell is divided into three fragments of solar cells, and so on. Details are not described herein again. Because a weight change of the entire solar cell may be ignored, the weight of the solar cell may be represented by using the number of fragments obtained by dividing the entire the solar cell, that is, the integer n obtained by rounding off the ratio of the long side to the short side of the solar cell. Based on the foregoing description, it can be seen that, when the isolation bumps 621 are designed, a height of the isolation bump 621, a distance between two adjacent isolation bumps 621, a weight of the solar cell (that is, the integer n obtained by rounding off the ratio of the long side to the short side of the solar cell), and the like need to be considered. In this way, the isolation bumps 621 can better avoid a risk of scratching the light receiving surface of the solar cell.

During design of the solar cell in this embodiment of the present application, *l,* h, and n satisfy a relation: $0 < l < \sqrt[4]{3 ∗ {10}^{5} {mm}^{3} ∗ \frac{hn}{N 0.098}}$, and a height h of an isolation bump 621 and a distance *l* between two adjacent isolation bumps 621 are each properly set, which can effectively avoid, when a plurality of solar cells is stacked, a case that a solar cell is subjected to a force and then bent to scratch a light receiving surface of a solar cell adjacent to the solar cell, and avoid affecting beautiful appearance and efficiency of the solar cell; and can further avoid a case that a small distance *l* between two adjacent isolation bumps 621 causes an increase in costs of material for manufacturing the isolation bumps and an increase in process difficulty, and avoid a case that a large distance *l* between two adjacent isolation bumps 621 causes a poor isolation effect. The solar cell in this embodiment of the present application have advantages such as a good isolation effect, low material costs, and low process difficulty.

In some embodiments, when N is 2, *l*, h, and n satisfy a relation: $0 < l < \sqrt[4]{15.3 ∗ {10}^{5} {mm}^{3} ∗ hn}$.

In this embodiment of the present application, during a stacking process, solar cells naturally descend and are aligned due to gravity. A limiting case of stacking a plurality of solar cells is that two solar cells are stacked, that is, N ≥ 2. When N ≥ 2, and *l*, h, and n satisfy the foregoing relation, the height h of the isolation bump 621 and the distance *l* between two adjacent isolation bumps 621 are each properly set, which can effectively avoid, when at least two solar cells are stacked, a case that an upper solar cell is subjected to a force and then bent to scratch a light receiving surface of a lower solar cell.

In some embodiments, when n is 1, that is, when the solar cell is an entire solar cell, *l*, h, and n satisfy a relation: $0 < l < \sqrt[4]{15.3 ∗ {10}^{5} {mm}^{3} ∗ h}$.

In some embodiments, when n is 2, that is, when the solar cell is a half solar cell, *l*, and h satisfy a relation: $0 < l < \sqrt[4]{30.6 ∗ {10}^{5} {mm}^{3} ∗ h}$.

In some other embodiments, when n is 3, that is, when the solar cell is a one-third solar cell, *l*, and h satisfy a relation: $0 < l < \sqrt[4]{45.9 ∗ {10}^{5} {mm}^{3} ∗ h}$.

Based on the formula $0 < l < \sqrt[4]{3 ∗ {10}^{5} {mm}^{3} ∗ \frac{hn}{N 0.098}}$, it can be learned that when a plurality of solar cells is stacked, a larger quantity of the solar cells arranged in a stacked manner indicates a smaller distance *l* between two adjacent isolation bumps 621 that needs to be set. When a plurality of solar cells is stacked, a quantity of the solar cells arranged in a stacked manner may be selected according to a requirement. In some examples, a value range of N may be 2 ≤ N ≤ 1000. For example, N may be one of 2, 3, 4, 10, 50, 10, 150, 200, 300, 400, 500, 600, 700, 800, 900, and 1000, or a plurality of values between the foregoing values. When N > 1000, an excessively large quantity of solar cells stacked increases a pressure on a bottom solar cell, and the bottom solar cell may be damaged or even cracked. In addition, a large total weight and total volume of the solar cells arranged in a stacked manner increase handling difficulty and risks; and alignment difficulty of the solar cells increases.

In some embodiments, 2 ≤ N ≤ 200. In this way, the quantity of the solar cells stacked is relatively proper, so that a transport requirement can be satisfied, and a damage risk can be reduced.

In some embodiments, a maximum dimension of a projection of the isolation bump 621 on the solar cell body 100a is d, satisfying d < *l*. In this way, a case that two adjacent isolation bumps 621 along the fourth direction X9 are connected and a case that two adjacent isolation bumps 621 along the fifth direction Y9 are connected can be avoided, material costs of the isolation bumps 621 can be saved, and process difficulty in manufacturing the plurality of isolation bumps 621 can be further reduced.

It is considered that if the maximum dimension of the projection of the isolation bump 621 on the solar cell body 100a is excessively small, difficulty in manufacturing the isolation bump is large, but if the maximum dimension of the projection of the isolation bump 621 on the solar cell body 100a is excessively large, light absorption of the solar cell is affected. Therefore, in some embodiments, 0.05 mm≤d≤2 mm.

When d < *l*, d falls within the foregoing range, and the isolation bump 621 is designed, *l* may be greater than 2 mm, *l* may be greater than 0.05 mm, or *l* may be greater than any value between 0.05 mm and 2 mm. When *l* is greater than 2 mm, a lower limit of a value of *l* is relatively large, which may reduce a quantity of the isolation bumps 621 and reduce material costs and process costs of the isolation bumps 621 while ensuring anti-scratch. When *l* is greater than 0.05 mm, a lower limit of a value of *l* is relatively small, a relatively small value may be selected for *l*, and a range within which *l* may be selected is increased. A relatively large quantity of the isolation bumps 621 may also be set, and therefore an isolation and protection effect can be to improved, to avoid scratching the light receiving surface of the solar cell.

It can be understood that, d may be set according to a use requirement. This is not specifically limited in this embodiment of the present application. For example, d is one of 0.05 mm, 0.06 mm, 0.07 mm, 0.08 mm, 0.09 mm, 0.1 mm, 0.2 mm, 0.3 mm, 0.5 mm, 0.7 mm, 1 mm, 1.2 mm, 1.4 mm, 1.6 mm, 1.8 mm, and 2 mm, or a plurality of values among the foregoing values.

In some embodiments, the solar cell body 100a has two oppositely provided first sides 911 and two oppositely provided second sides 912, the first sides 911 are perpendicular to the second sides 912, the fourth direction X9 is parallel to the first sides 911, and the fifth direction Y9 is parallel to the second sides 912; or an acute angle is set both between the fourth direction X9 and the first sides 911 and between the fifth direction Y9 and the second sides 912. In this way, the isolation bumps 621 are arranged relatively regularly. Compared with random arrangement of the isolation bumps 621, the surface of the solar cell body 100a may be better fully protected, where an extension direction of the isolation bumps 621 and the first sides 911 intersect with each other and form an included angle being an acute angle.

In some other embodiments, referring to FIG. 28, the fifth direction Y9 is parallel to the first sides 911, that is, an extension direction of each of the plurality of rows of isolation bumps 621 is parallel to the first sides 911.

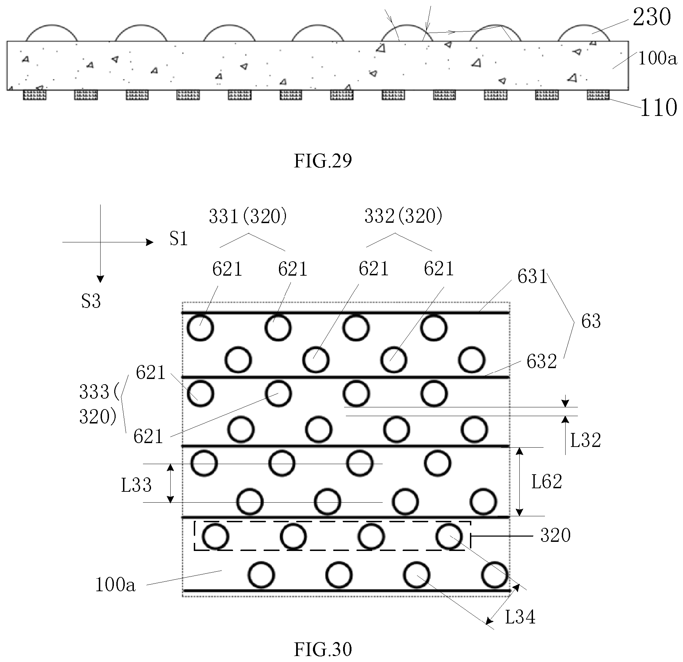

The following describes the structure of the solar cell in an eleventh group of embodiments of the first aspect of the present application with reference to FIG. 29.

In this group of embodiments, the isolation member includes a plurality of isolation protrusions 230 arranged at intervals. As shown in FIG. 29, a solar cell according to some embodiments of the present application includes: a solar cell body 100a. At least one face of the solar cell body 100a is provided with a plurality of isolation protrusions 230 arranged at intervals. In some examples, a refractive index of the isolation protrusion 230 is less than a refractive index of the solar cell body 100a.

In this embodiment of the present application, by setting a refractive index of the isolation protrusion 230 to be less than a refractive index of the solar cell body 100a, as shown by arrows in FIG. 29, when incident light is shed on the isolation protrusion 230, most of the light is transmitted through the isolation protrusion 230 and is absorbing by the solar cell, and a small part of the light is repeatedly refracted or reflected between the plurality of isolation protrusions 230 and is absorbing by the solar cell again, thereby forming a light trapping effect, increasing a light absorbing rate of the solar cell, and improving conversion efficiency of the solar cell.

In an embodiment, a plurality of pyramid structures is provided on a side surface of the solar cell body 100a on which the isolation protrusion 230 is provided, and the isolation protrusion 230 covers at least two pyramid structures.

In this embodiment of the present application, a plurality of pyramid structures is provided on a side surface of the solar cell body 100a on which the isolation protrusion 230 is provided, so that the isolation protrusion 230 covers at least two pyramid structures. Therefore, a light trapping effect formed on the surface of the solar cell body 100a can be enhanced through a cooperative effect of the plurality of isolation protrusions 230 and the plurality of pyramid structures, thereby further improving conversion efficiency of the solar cell.

For a height of the isolation protrusion 230, reference may be made to other embodiments. In some examples, a height of the isolation protrusion along the direction perpendicular to the first surface is 5 µm to 40 µm.

The following describes the structure of the solar cell in a twelfth group of embodiments of the first aspect of the present application with reference to FIG. 30 and FIG. 31, FIG. 16, and FIG. 5.

In this group of embodiments, as shown in FIG. 30, the solar cell includes: a solar cell body 100a. The solar cell body 100a includes a first surface and a second surface that are opposite, the back surface is a first surface, and the light receiving surface is a second surface; the electrode includes a plurality of fingers 63 provided on the first surface of the solar cell body 100a; the isolation member includes a plurality of isolation structures 320 provided on at least one of the first surface and the second surface of the solar cell body 100a, and the plurality of isolation structures 320 are arranged along a direction perpendicular to the finger 63.

Specifically, as shown in FIG. 30, an extension direction of the isolation structure 320 and an extension direction of the finger 63 are the same, and are both parallel to a direction S1. A plurality of fingers 63 is arranged at intervals along a direction S3, a plurality of isolation structures 320 is arranged at intervals along the direction S3, and the direction S1 is perpendicular to the direction S3.

In some embodiments, a distance between two adjacent fingers 63 is greater than a distance between two adjacent isolation structures 320 along the direction perpendicular to the finger 63.

In this embodiment of the present application, a plurality of fingers 63 is provided on the first surface of the solar cell body 100a, and a plurality of isolation structures 320 is provided on at least one of the first surface and the second surface of the solar cell body 100a. Because a distance between two adjacent fingers 63 is greater than a distance between two adjacent isolation structures 320 along a direction perpendicular to the plurality of fingers 63, the isolation structures 320 are arranged densely, so as to increase a covering area of the isolation structures 320 on at least one of the first surface and the second surface. In this way, in a process of stacking and transferring a plurality of solar cells, the isolation bump 621 may better isolate and protect the surface of the solar cell body 100a, thereby reducing a risk that a finger, a busbar, a terminal line, a pad, or the like on one solar cell of two solar cells arranged in a stacked manner scratches a light receiving surface of the other solar cell, to ensure product quality of the solar cells.

The busbar, the finger, the pad, the terminal line, and the like are all provided on the first surface of the solar cell body 100a. The finger 63 may be a positive grid line or a negative grid line.

In some embodiments, the isolation structure 320 may be a long strip-shaped structure.

In some other embodiments, the isolation structure 320 may include a plurality of isolation bumps 621 arranged along a direction parallel to the finger 63.

In this embodiment of the present application, the isolation structure 320 is designed as a plurality of isolation bumps 621 arranged in a row, so that manufacturing costs of the isolation structure 320 can be reduced, blocking of the solar cell body 100a by the isolation structure 320 can be reduced, and a light absorbing effect of the solar cell body 100a can be improved.

As shown in FIG. 30, a plurality of isolation bumps 621 in a dashed box forms an isolation structure 320.

In some examples, a distance between two adjacent fingers 63 is greater than a distance between two adjacent isolation structures 320 along the direction perpendicular to the finger 63, so that the isolation structures 320 are densely provided. At least two isolation structures 320, for example, two, three, or more isolation structures 320 may be provided between two adjacent finger 63.

In this embodiment of the present application, the two adjacent fingers 63 may be two fingers 63 of a same polarity, that is, two fingers 63 of a positive polarity or two fingers 63 of a negative polarity. The two adjacent fingers 63 may alternatively be two fingers 63 of different polarities, that is, one finger 63 of a positive polarity and one finger 63 of a negative polarity.

It should be noted that, a distance between two adjacent fingers 63 is a width of a gap between the two adjacent fingers 63 in the direction S3, that is, a distance between boundaries of the two adjacent fingers 63 in the direction S3, that is, a minimum distance between the two adjacent fingers 63 in the direction S3. A distance between two adjacent isolation structures 320 in the direction perpendicular to the finger 63 is a width of a gap between the two adjacent isolation structures 320 in the direction S3, that is, a distance between boundaries of the two adjacent isolation structures 320 in the direction S3, that is, a minimum distance between the two adjacent isolation structures 320 in the direction S3. As shown in FIG. 30, a distance between two adjacent fingers 63 is L62, and a distance between two adjacent isolation structures 320 along the direction perpendicular to the finger 63 is L32, where L62>L32.

In a stacking process, when an upper solar cell falls onto a lower solar cell, there is a relatively low probability that the upper solar cell completely covers the lower solar cell, and usually, the upper solar cell is deflected relative to the lower solar cell. In this embodiment of the present application, because relatively dense isolation structures 320 may be arranged on at least one of the first surface and the second surface, a covering area of the isolation structures 320 on the second surface is increased. In this way, the density of the isolation structures 320 is increased, so as to increase an isolating and protecting area of the isolation structures 320 on the second surface, thereby greatly reducing a probability that the light receiving surface is scratched by a finger, a busbar, a terminal line, a pad, or the like on an adjacent solar cell.

In some embodiments of the present application, a distance between two adjacent fingers 63 is greater than a distance between centers of two adjacent isolation structures 320 along the direction perpendicular to the finger 63, so that a density of the isolation structures 320 can be further improved, and an isolation and protection effect of the isolation structures 320 can be improved.

Specifically, as shown in FIG. 30, a distance between centers of two adjacent isolation structures 320 along the direction S3 perpendicular to the finger 63 is L33, where L62>L33>L32.

In some examples, the center of the isolation structure 320 is a center of the isolation structure 320 in the direction S3.

In some embodiments of the present application, as shown in FIG. 30, in two adjacent isolation structures 320, a plurality of isolation bumps 621 in one isolation structure 320 is intersected with a plurality of isolation bumps 621 in the other isolation structure 320.

In this embodiment of the present application, the isolation bumps 621 in the plurality of isolation structures 320 may be more evenly arranged on the second surface, thereby further improving an effect of isolating and protecting the surface of the solar cell body 100a by the isolation bumps 621.

In some embodiments of the present application, a distance between two adjacent fingers 63 is greater than a fourth distance; and the fourth distance is a minimum distance between centers of two isolation bumps 621 respectively located in two adjacent isolation structures 320, which can further improve a density of the isolation structures 320.

Specifically, the fourth distance is a length of a connection line between centers of two isolation bumps 621 in two adjacent isolation structures 320. As shown in FIG. 30, a minimum distance between centers of two isolation bumps 621 located in two adjacent isolation structures 320 is L34, where L62>L34>L32.

Specifically, a center of the isolation bump 621 is a center of the isolation bump 621 in a direction perpendicular to the finger 63. For example, when the isolation bump 621 is a circular bump, a center of the isolation bump 621 is a circle center of the isolation bump 621.

In some embodiments of the present application, the plurality of isolation bumps 621 in the plurality of isolation structures 320 are arranged in an array, so that simple and convenient arrangement of the isolation structures 320 can be improved, and arrangement of the isolation bumps 621 can be diversified.

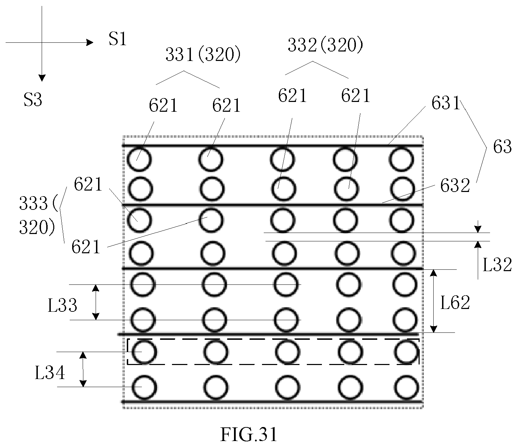

Specifically, as shown in FIG. 31, the plurality of isolation bumps 621 in the plurality of isolation structures 320 are arranged in a plurality of rows along the direction S3 perpendicular to the finger 63, and are arranged in a plurality of columns along the direction S1 parallel to the finger 63.

In some embodiments, the solar cell includes a finger 63 and a pad, and a height of the isolation structure 320 is less than or equal to a height of at least one of the finger 63 and the pad. In this way, materials of the isolation structure 320 can be reduced, so as to reduce manufacturing costs of the isolation structure 320. In this case, a height and a quantity of isolation bumps 621, an arrangement manner of the plurality of isolation bumps 621, a stack manner of the plurality of solar cells, or the like may be set, so that the isolation bumps 621 may play a role in preventing a finger 63, a busbar, a pad, a terminal line, or the like from scratching the surface of the solar cell body 100a.

Specifically, the pad is used to electrically connect to the interconnection member, so as to connect different solar cells.

In some other embodiments, the solar cell includes a finger 63, a pad, and a busbar. The busbar is electrically connected to a plurality of fingers 63 having a same polarity, and is configured to converge currents collected by the fingers 63 having the same polarity. The pad is electrically connected to the busbar. A height of the isolation structure 320 is less than or equal to a height of at least one of the pad, the finger 63, and the busbar. In this way, materials of the isolation structure 320 can be reduced, so as to reduce manufacturing costs of the isolation structure 320. In this case, a height and a quantity of isolation bumps 621, an arrangement manner of the plurality of isolation bumps 621, a stack manner of the plurality of solar cells, or the like may be set, so that the isolation bumps 621 may play a role in preventing a finger, a busbar, a pad, a terminal line, or the like from scratching the surface of the solar cell body 100a.

In some other embodiments, the solar cell includes a finger, a pad, and a terminal line, each finger 63 of a plurality of fingers located at the edge of the solar cell body 100a includes a plurality of finger segments sequentially arranged along an extension direction of the finger 63, and the terminal line is electrically connected to the plurality of finger segments located at the edge of the solar cell body 100a. A height of the isolation structure 320 is less than or equal to a height of at least one of the pad, the finger 63, and the terminal line. In this way, materials of the isolation structure 320 can be reduced, so as to reduce manufacturing costs of the isolation structure 320. In this case, a height and a quantity of isolation bumps 621, an arrangement manner of the plurality of isolation bumps 621, a stack manner of the plurality of solar cells, or the like may be set, so that the isolation bumps 621 may play a role in preventing a finger, a busbar, a pad, a terminal line, or the like from scratching the surface of the solar cell body 100a.

Specifically, the terminal line is used to connect to fingers 63 of a same polarity, and the terminal line may include a first terminal line connecting a plurality of first sub-fingers 6311, and a second terminal line connecting a plurality of second sub-fingers 6321.

In some embodiments of the present application, the width of the finger 63 is greater than a distance between two adjacent isolation structures 320 along the direction perpendicular to the finger 63. In this way, when solar cells are stacked, a finger 63 on one solar cell may be in contact with at least one isolation structure 320, so that the isolation structure 320 can well isolate and protect the surface of the solar cell body 100a, thereby greatly reducing the risk of scratching the surface of the solar cell body 100a.

In some other embodiments, the width of the finger 63 may alternatively be less than or equal to greater than a distance between two adjacent isolation structures 320 along the direction perpendicular to the finger 63, to reduce manufacturing costs of the isolation structures 320. In this case, a height and a quantity of isolation bumps 621, an arrangement manner of the plurality of isolation bumps 621, a stack manner of the plurality of solar cells, or the like may be set, so that the isolation bumps 621 may play a role in preventing a finger, a busbar, a pad, a terminal line, or the like from scratching the surface of the solar cell body 100a.

The following describes a photovoltaic module according to a second aspect of the present application in detail.

The photovoltaic module in the embodiments of the present application includes the solar cell according to any one of the foregoing embodiments. The photovoltaic module has a same technical effect as that of the foregoing solar cell, and reference may be made to the foregoing descriptions.

In an embodiment, the photovoltaic module further includes a plurality of solar cell strings. Each solar cell string includes a plurality of solar cells and a plurality of interconnection members, and the interconnection members are configured to connect the plurality of solar cells in series.

In this embodiment of the present application, the isolation member performs a function of isolating and protecting the surface of the solar cell body. In addition, during a laminating process of the photovoltaic module, the isolation member may further perform a buffer function, so as to reduce stress of the solar cell at an interconnection member during the laminating process, thereby reducing a risk of a hidden crack of the solar cell during the laminating process.

In an embodiment, the interconnection member may be a welding strip, a metal wire, an electrically conductive tape, or the like.

In an embodiment, the photovoltaic module further includes a cover plate, a back plate, and a packaging adhesive film. The solar cell is packaged between the cover plate and the back plate by using the packaging adhesive film. The isolation member is at least partially cross-linked to the packaging adhesive film after being subjected to a lamination process.

The isolation member is at least partially cross-linked to the packaging adhesive film after being subjected to a lamination process. In other words, the packaging adhesive film 730 is completely fused or is partially fused with the isolation member 120. After the solar cell is packaged by using the packaging adhesive film, the isolation member is fused and cross-linked to the packaging adhesive film. The isolation member has no impact on the appearance of the photovoltaic module manufactured by processing the solar cell, and existence of the isolation member cannot be detected either under intense flashlight or under an EL test, thereby not affecting the efficiency of the photovoltaic module.

In an embodiment, the photovoltaic module further includes a polymer layer; the solar cell includes: a solar cell body, where the solar cell body has a light receiving surface and a back surface, the back surface is provided with an electrode, the light receiving surface is provided with a plurality of isolation traces arranged at intervals, and extension directions of at least part of the isolation traces are intersected with an extension direction of the electrode; and the polymer layer is provided on the light receiving surface of the solar cell body, and the polymer layer covers the isolation traces.

In an embodiment, the photovoltaic module further includes a polymer layer; the solar cell is a back contact solar cell, the back contact solar cell includes a solar cell body, a plurality of support grid lines, and a plurality of isolation traces; the support grid lines are provided on the back surface of the solar cell body; and the isolation trace is provided on the light receiving surface of the solar cell body, and an arrangement direction of the isolation trace is parallel to an extension direction of the support grid line; at least part of the plurality of support grid lines overlaps with projections of the plurality of isolation traces on the back surface of the solar cell body; and the polymer layer is provided on the light receiving surface of the solar cell body, and the polymer layer covers the isolation traces.

In an embodiment, if the solar cell has a hollow-out structure, at least a part of the hollow-out structure is cross-linked to the packaging adhesive film after being subjected to a lamination process.

In some embodiments, the cover plate and the back plate may be at least understood as glass. A conventional laminating process is usually performed on the photovoltaic module. In the laminating process of solar cells, the isolation member is heated and fused, and is cross-linked to an adhesive film for component packaging, and the isolation member becomes a part of the packaging adhesive film. Therefore, the isolation member does not need to be removed during a production process of the photovoltaic module, thereby simplifying a laminating operation process, and helping improve the laminating efficiency.

With reference to FIG. 22, an example of the photovoltaic module according to this embodiment of the present application is described in detail.

In this example, a peeling strength between the isolation member 120 and the solar cell 100 is greater than a peeling strength between the isolation member 120 and the packaging adhesive film 730.

The peeling strength between the isolation member 120 and the solar cell 100 is greater than the peeling strength between the isolation member 120 and the packaging adhesive film 730, so that the solar cell 100 and the isolation member 120 can remain integral all the time. During a process of laminating, the isolation member 120 does not deviate, thereby avoiding damaging the solar cell 100, and reducing a hidden crack risk. In addition, the isolation member 120 increases a contact structure between the solar cell 100 and the packaging adhesive film 730, forms an adhesive covering situation of point-surface contact, and reduces a direct stress on the solar cell 100 during a process of laminating, thereby avoiding a hidden crack in the solar cell 100, and improving module stability, to reduce a risk of a hidden crack caused by an inertial offset of the solar cell 100 in a circulating and transferring process.

The peeling strength refers to a maximum force required when an attached material is peeled from a contact surface per unit width. It reflects a bonding strength of the material. In this embodiment of the present application, the peeling strength is an adhesion strength between the solar cell 100 and the packaging adhesive film 730, between the packaging adhesive film 730 and the back plate 52, between the packaging adhesive film 730 and the cover plate 51, between the solar cell 100 and the isolation member 120, between the isolation member 120 and the packaging adhesive film 730, and the like. The peeling strength is related to the endurance and performance of the photovoltaic module in various environmental conditions.

In the related art, there are a plurality of test manners for the peeling strength. It can be understood that, how to measure the peeling strength is not specifically limited in this embodiment of the present application. For example, the peeling strength is measured by using a dedicated test apparatus such as a peeling strength tester. For another example, the packaging adhesive film 730 and the solar cell 100 are manually peeled from each other, and measurement is performed by using a tensometer.

In some embodiments, the peeling strength between the packaging adhesive film 730 and the solar cell 100 is greater than the peeling strength between the packaging adhesive film 730 and the cover plate 51, and/or the peeling strength between the packaging adhesive film 730 and the solar cell 100 is greater than the peeling strength between the packaging adhesive film 730 and the back plate 52.

According to the photovoltaic module in this embodiment of the present application, the adhesion strength between the packaging adhesive film 730 and the solar cell 100 is relatively high, and the bonding between the packaging adhesive film 730 and the solar cell 100 is more secure. Even if the photovoltaic module is used for a long time under the action of gravity, or is vibrated or shaken, delamination is not easy to occur, thereby reducing a delamination risk, and further prolonging the service life of the photovoltaic module.

The isolation members 120 provided on the solar cell 100 may form a plurality of adhesive points, so that the packaging adhesive film 730 is more securely attached to the solar cell 100 by using the plurality of adhesive points, and a covering situation of the packaging adhesive film 730 of point-surface contact is formed. A covering area of the packaging adhesive film 730 is larger, mobility of the adhesive is smoother in a laminating process, and the edge of the packaging adhesive film 730 is not easy to camber, thereby reducing a height difference or a step between the edge of the solar cell 100 and the packaging adhesive film 730. For the packaging adhesive film 730 that is in contact with the solar cell 100, because of the existence of the isolation member 120, the packaging adhesive film 730 has relatively low stiffness, so as to reduce pressure on the solar cell 100 in a laminating process, and reduce a risk of a hidden crack of the solar cell 100.

In the foregoing structure of this embodiment of the present application, the peeling strength between the packaging adhesive film 730 and the solar cell 100 is greater than the peeling strength between the packaging adhesive film 730 and the cover plate 51; or the peeling strength between the packaging adhesive film 730 and the solar cell 100 is greater than the peeling strength between the packaging adhesive film 730 and the back plate 52; or the peeling strength between the packaging adhesive film 730 and the solar cell 100 is greater than the peeling strength between the packaging adhesive film 730 and the cover plate 51, and greater than the peeling strength between the packaging adhesive film 730 and the back plate 52. Therefore, through strong adhesion between the packaging adhesive film 730 and the solar cell 100, sealing and waterproofing effects on the solar cell 100 are achieved, and optical-to-electrical conversion stability is improved.

The following describes a solar cell stack structure according to a third aspect of the present application in detail.

The solar cell stack structure includes a plurality of solar cells 100 that are stacked, where a back surface of the solar cell 100 is provided with an electrode 110. The solar cell may be the solar cell according to any one of the foregoing embodiments.

In some embodiments, at least a part of the solar cell stack structure is formed by a plurality of groups of solar cells; each group of solar cells includes two solar cells 100 whose back surfaces are in contact with each other; and for two adjacent solar cells 100 whose light receiving surfaces are in contact with each other in the solar cell stack structure, a protective adhesive layer 300 is provided on a light receiving surface of at least one solar cell 100. (the figure shows a solution in which a protective adhesive layer 300 is provided on one solar cell 100)

In this embodiment of the present application, at least a part of the solar cell stack structure (at least a part of the solar cell stack structure includes an even number of solar cells) may be formed by a plurality of groups of solar cells W, each group of solar cells W is formed by two solar cells 100 whose back surfaces are in contact with each other, and the plurality of groups of solar cells W are stacked to form the solar cell stack structure. In such a stacking manner, surface contact in the stack structure includes contact between a back surface of a solar cell and a back surface of a solar cell in each group of solar cells W, and contact between a light receiving surface of a solar cell and a light receiving surface of a solar cell in each adjacent group of solar cells W.

There is an electrode 110 on a back surface of a solar cell 100. Therefore, with regard to contact between a back surface of a solar cell 100 and a back surface of a solar cell 100, support may be formed by mutual contact between respective electrodes 110 of the two solar cells 100, so that the back surfaces of the solar cells 100 are not scratched due to contact with another structure, thereby protecting the back surfaces of the solar cells 100.

With regard to contact between a light receiving surface of a solar cell 100 and a light receiving surface of a solar cell 100, in this embodiment of the present application, to avoid surface scratching caused by direct contact between respective light receiving surfaces of the two solar cells 100, a protective adhesive layer 300 may be provided on a light receiving surface of at least one solar cell of the two solar cells 100 whose light receiving surfaces are in contact with each other, so that the respective light receiving surfaces of the two solar cells 100 are not in direct contact with each other. The respective light receiving surfaces of the two solar cells 100 may be supported and buffered by using the protective adhesive layer 300, thereby protecting the light receiving surfaces of the solar cells 100. In addition, the protective adhesive layer is fixed to the light receiving surface of the solar cell. The protective adhesive layer is not prone to fall off or have a position offset, so that the protective adhesive layer can produce a continuous protective effect on the light receiving surface of the solar cell.

In an embodiment, for two adjacent solar cells 100 whose light receiving surfaces are in contact with each other in the solar cell stack structure, a protective adhesive layer 300 is provided on a light receiving surface of one of the solar cells 100. In this embodiment of the present application, a protective adhesive layer is provided on only a light receiving surface of one solar cell of two adjacent solar cells whose light receiving surfaces are in contact with each other. Therefore, a protective adhesive layer may not need to be provided on a light receiving surface of each solar cell. Based on ensuring protection on the light receiving surfaces of the solar cells, an entire amount of adhesive is reduced, thereby saving related costs. Certainly, in another implementation, a protective adhesive layer 300 may alternatively be provided on each of light receiving surfaces of two solar cells 100 whose light receiving surfaces are in contact with each other. This is not limited in this embodiment of the present application.

In an embodiment, in each group of solar cells W, an electrode 110 of one solar cell 100 is crossed with an electrode 110 of the other solar cell 100. For example, in each group of solar cells W, an electrode 110 of one solar cell 100 is perpendicular to an electrode 110 of the other solar cell 100. The electrode 110 may be a busbar, or may be a finger.

In an embodiment, the electrode 110 includes a busbar and a finger. if a protrusion height of the busbar is greater than a protrusion height of the finger, in each group of solar cells W, a busbar of one solar cell 100 is crossed with a busbar of the other solar cell 100; or if a protrusion height of the busbar is less than a protrusion height of the finger, in each group of solar cells W, a finger of one solar cell 100 is crossed with a finger of the other solar cell 100.

It should be noted that, if the protrusion height of the busbar of the solar cell is equal to the protrusion height of the finger, because the busbar of the solar cell is perpendicular to the finger, an arrangement manner between an electrode of one solar cell and an electrode of the other solar cell in each group of solar cells does not need to be considered. The arrangement manner between the two electrodes is not specifically limited in this embodiment of the present application.

In an embodiment, the electrode includes only a finger; and in each group of solar cells, a finger of one solar cell is crossed with a finger of the other solar cell.

In the present application, the specific features, structures, materials, or characteristics described in the embodiments may be combined in a proper manner in any one or more of the embodiments or examples.

In the descriptions of this specification, descriptions using reference terms "an embodiment", "some embodiments", "an exemplary embodiment", "an example", "a specific example", or "some examples" mean that specific characteristics, structures, materials, or features described with reference to the embodiment or example are included in at least one embodiment or example of the present application. In this specification, exemplary descriptions of the foregoing terms do not necessarily refer to the same embodiment or example.

Although the embodiments of the present application have been shown and described, a person of normal skill in the art should understand that various changes, modifications, replacements and variations may be made to the embodiments without departing from the principles and spirit of the present application, and the scope of the present application is as defined by the appended claims and their equivalents.

The subject-matter of the present invention relates, *inter alia*, to the following aspects.
1. A solar cell, comprising: a solar cell body, wherein the solar cell body has a light receiving surface and a back surface, wherein the back surface is provided with an electrode, and the light receiving surface and/or the back surface is provided with an isolation member.
2. The solar cell according to aspect 1, wherein
   the light receiving surface is provided with a plurality of isolation members arranged at intervals, and an extension direction of at least part of the plurality of isolation members is intersected with an extension direction of the electrode.
3. The solar cell according to aspect 2, wherein the isolation member is formed by a plurality of dotted protrusions and/or a plurality of linear protrusions sequentially arranged at intervals along a preset direction, and the preset direction is an extension direction of the isolation member; or the isolation member is a strip-shaped protrusion extending continuously;
   and/or
   a first included angle is formed between the extension direction of the at least part of the plurality of isolation members and the extension direction of the electrode, and the first included angle ranges from 30° to 150°.
4. The solar cell according to aspect 2 or 3, wherein the isolation member comprises a plurality of first isolation members arranged at intervals, extension directions of the plurality of first isolation members are the same, and the extension direction of the plurality of first isolation members is intersected with the extension direction of the electrode.
5. The solar cell according to aspect 4, wherein the isolation member further comprises a plurality of second isolation members arranged at intervals, and an extension direction of the plurality of second isolation members is intersected with the extension direction of the plurality of first isolation members and the extension direction of the electrode.
6. The solar cell according to aspect 5, wherein:
   the light receiving surface comprises four regions being respectively a first region, a second region, a third region, and a fourth region;
   the first region and the second region are arranged along a first direction, and the third region and the fourth region are arranged along the first direction;
   the first region and the third region are arranged along a second direction, and the second region and the fourth region are arranged along the second direction, the first direction being perpendicular to the second direction; and
   the plurality of first isolation members are provided in the second region and the third region, and the plurality of second isolation members are provided in the first region and the fourth region.
7. The solar cell according to aspect 2, wherein the back surface is provided with a busbar and a finger that are connected to each other, and the electrode is a higher one of the busbar and the finger;
   or the back surface is provided with a finger, and the electrode is the finger.
8. The solar cell according to aspect 1, wherein:
   a plurality of electrodes sequentially arranged at intervals along a third direction are provided on the back surface; and
   the isolation member comprises a first protective member, at least one of the light receiving surface and the back surface is provided with a plurality of first protective members that are arranged at intervals, a maximum dimension of an orthographic projection of each of the plurality of first protective members on the back surface along the third direction is greater than a distance between two adjacent electrodes.
9. The solar cell according to aspect 1, wherein
   the isolation member is a protective adhesive unit;
   a protective adhesive layer is provided on at least one of the back surface and the light receiving surface of the solar cell, the back surface is provided with a plurality of electrodes, the protective adhesive layer comprising a plurality of protective adhesive units provided at intervals; and
   a minimum distance between two adjacent protective adhesive units is less than a projection width of the electrode on the surface of the solar cell.
10. The solar cell according to aspect 9, wherein
   the electrode comprises a terminal line, a welding point, and a finger, the terminal line is electrically connected to a part of the finger, and the minimum distance between the two adjacent protective adhesive units is less than a projection width of a highest one of the terminal line, the welding point, and the finger on the back surface of the solar cell;
      or
   the electrode comprises a welding point, a busbar, and a finger, and the minimum distance between the two adjacent protective adhesive units is less than a projection width of a highest one of the welding point, the busbar, and the finger on the back surface of the solar cell;
      or
   the electrode comprises a welding point and a finger, and the minimum distance between the two adjacent protective adhesive units is less than a projection width of a higher one of the welding point and the finger on the back surface of the solar cell.
11. The solar cell according to aspect 1, wherein
   the isolation member comprises a plurality of first isolation protrusions and a plurality of second isolation protrusions;
   the electrode comprises a plurality of grid lines;
   the plurality of first isolation protrusions are provided on the back surface of the solar cell body, and the first isolation protrusions protrude from the back surface of the solar cell body;
   the plurality of second isolation protrusions are provided on the light receiving surface of the solar cell body, and the second isolation protrusions protrude from the light receiving surface of the solar cell body;
   the plurality of grid lines are provided on at least one surface of the solar cell body;
   in a thickness direction of the solar cell body, a height of at least one of the plurality of first isolation protrusions and the plurality of second isolation protrusions is greater than heights of all of the grid lines; and
   projections of the plurality of second isolation protrusions on the back surface of the solar cell body do not intersect with the plurality of first isolation protrusions, or the projections of the plurality of second isolation protrusions on the back surface of the solar cell body are partially intersected with the plurality of first isolation protrusions.
12. The solar cell according to aspect 1, wherein the solar cell is a back contact solar cell;
   the isolation member comprises an insulation adhesive;
   the electrode comprises a grid line, the insulation adhesive and the grid line are provided on the back surface of the solar cell body; and
   in a direction away from the solar cell body, a height of the insulation adhesive is greater than a height of the grid line, and a Mohs hardness of an end portion of the insulation adhesive that faces away from the back contact solar cell ranges from 2 to 7.
13. The solar cell according to aspect 12, wherein:
   the insulation adhesive comprises a first insulation adhesive and a second insulation adhesive, the first insulation adhesive is connected to the back surface of the solar cell body and covers a preset position of the grid line, and the second insulation adhesive is connected to at least part of the first insulation adhesive and covers a surface of the first insulation adhesive that faces away from the solar cell body;
      or
   the insulation adhesive comprises a first insulation adhesive and a second insulation adhesive, the first insulation adhesive is connected to the back surface of the back contact solar cell and covers at least part of the grid line, and the second insulation adhesive having a bump-shaped structure and is connected to at least part of a surface of the first insulation adhesive that faces away from the solar cell body; or the insulation adhesive comprises a first insulation adhesive, and the first insulation adhesive is connected to the back surface of the back contact solar cell and covers at least part of the grid line.
14. The solar cell according to aspect 1, wherein:
   the solar cell is a back contact solar cell;
   the electrode comprises a plurality of support grid lines provided on the back surface of the solar cell body;
   the isolation member comprises a plurality of isolation protrusions provided on the light receiving surface of the solar cell body and protruding from the light receiving surface of the solar cell body, and an arrangement direction of the plurality of isolation protrusions is parallel to an extension direction of the support grid line; and
   at least part of the plurality of support grid lines overlaps with projections of the plurality of isolation protrusions on the back surface of the solar cell body.
15. The solar cell according to aspect 1, wherein:
   the back surface is a first surface, and the light receiving surface is a second surface;
   the electrode comprises a plurality of fingers provided on the first surface of the solar cell body;
   a plurality of isolation members are provided on the first surface and/or the second surface of the solar cell body, an extension direction of the plurality of isolation members is intersected with an extension direction of the plurality of fingers; and
   the plurality of isolation members comprise a plurality of isolation bumps arranged along the extension direction of the isolation member, a distance between two adjacent isolation bumps of a same isolation member in the extension direction of the isolation member is greater than a distance between two adjacent fingers.
16. The solar cell according to aspect 15, wherein a distance between the two adjacent isolation bumps of the same isolation member in a direction perpendicular to the plurality of fingers is greater than the distance between the two adjacent fingers.
17. The solar cell according to aspect 15, wherein the plurality of fingers comprise first fingers and second fingers that are alternately arranged along a direction perpendicular to the plurality of fingers; and
   the distance between the two adjacent isolation bumps of the same isolation member in the extension direction of the isolation member is greater than a distance between two adjacent first fingers;
   and/or the distance between the two adjacent isolation bumps of the same isolation member in the extension direction of the isolation member is greater than a distance between two adjacent second fingers.
18. The solar cell according to aspect 1, wherein:
   the light receiving surface comprises a fifth region and a plurality of sixth regions;
   the isolation member comprises a plurality of isolation members provided on the light receiving surface of the solar cell body, a density of a part of the plurality of isolation members located in the fifth region is greater than a density of a part of the plurality of isolation members located in each of the plurality of sixth regions; and
   the solar cell further comprises a plurality of fingers provided on the back surface of the solar cell body, the plurality of sixth regions are arranged along an extension direction of the plurality of finger, and an extension direction of each of the plurality of sixth regions is perpendicular to the plurality of fingers.
19. The solar cell according to aspect 1, wherein:
   one of the light receiving surface and the back surface is a first surface, and the other is a second surface; and
   the isolation member comprises a plurality of isolation bumps provided on at least one of the first surface and the second surface of the solar cell body, the plurality of isolation bumps is arranged in a plurality of rows along a first direction, each of the plurality of rows of isolation bumps comprise a plurality of isolation bumps arranged along a second direction,
   wherein *l* is a larger one of a distance between two adjacent isolation bumps along the first direction and a distance between two adjacent isolation bumps along the second direction, h is a height of each of the plurality of isolation bumps, and n is an integer obtained by rounding off a ratio of a long side to a short side of the solar cell, and *l*, h, and n satisfy a relation: $0 < l < \sqrt[4]{15.3 ∗ {10}^{5} {mm}^{3} ∗ hn} .$
20. The solar cell according to aspect 1, wherein the back surface is a first surface, and the light receiving surface is a second surface;
   the electrode comprises a plurality of fingers provided on the first surface of the solar cell body; and
   the isolation member comprises a plurality of isolation structures provided on at least one of the first surface and the second surface of the solar cell body, and the plurality of isolation structures are arranged along a direction perpendicular to the finger,
   wherein a distance between two adjacent fingers is greater than a distance between two adjacent isolation structures along the direction perpendicular to the finger.
21. The solar cell according to aspect 1, wherein an orthographic projection of the isolation member on the back surface at least partially overlaps with the electrode;
   and/or a coverage ratio of the isolation member on at least one of the light receiving surface and the back surface is S81, wherein 0.5% ≤ S81 ≤ 10%;
      and/or
   a height of the isolation member in a direction facing away from the solar cell body ranges from 2 µm to 80 µm.
22. A photovoltaic module, comprising the solar cell according to any one of aspects 1 to 21.
23. The photovoltaic module according to aspect 22, wherein the photovoltaic module further comprises a cover plate, a back plate, and a packaging adhesive film,
   wherein the solar cell is packaged between the cover plate and the back plate by using the packaging adhesive film; and
   a peeling strength between the isolation member and the solar cell is greater than a peeling strength between the isolation member and the packaging adhesive film.
24. A solar cell stack structure, comprising a plurality of solar cells according to any one of aspects 1 to 21 arranged in a stacked manner.

## Claims

1. A solar cell, comprising: a solar cell body, wherein the solar cell body has a light receiving surface and a back surface, wherein the back surface is provided with an electrode, and the light receiving surface is provided with a plurality of isolation members arranged at intervals, and an extension direction of at least part of the plurality of isolation members is intersected with an extension direction of the electrode,
each isolation member is formed by a plurality of dotted protrusions and/or a plurality of linear protrusions sequentially arranged at intervals along a preset direction, and the preset direction is an extension direction of each isolation member;
a first included angle is formed between the extension direction of at least part of the plurality of isolation members and the extension direction of the electrode, and the first included angle ranges from 30° to 150°.

2. The solar cell according to claim 1, wherein the isolation member comprises a plurality of first isolation members arranged at intervals, extension directions of the plurality of first isolation members are the same, and the extension direction of the plurality of first isolation members is intersected with the extension direction of the electrode.

3. The solar cell according to claim 2, wherein the isolation member further comprises a plurality of second isolation members arranged at intervals, and an extension direction of the plurality of second isolation members is intersected with the extension direction of the plurality of first isolation members and the extension direction of the electrode.

4. The solar cell according to claim 3, wherein,
the light receiving surface comprises four regions being respectively a first region, a second region, a third region, and a fourth region;
the first region and the second region are arranged along a first direction, and the third region and the fourth region are arranged along the first direction;
the first region and the third region are arranged along a second direction, and the second region and the fourth region are arranged along the second direction, the first direction being perpendicular to the second direction; and
the plurality of first isolation members are provided in the second region and the third region, and the plurality of second isolation members are provided in the first region and the fourth region.

5. The solar cell according to claim 1 to 4, wherein a distance between two adjacent electrodes along a direction perpendicular to the extension direction of the electrodes is a first distance; and a distance between two adjacent isolation members along a direction perpendicular to the extension direction of the isolation members is a second distance, and the second distance is less than the first distance.

6. The solar cell according to any of claims 1 to 5, wherein the back surface is provided with a busbar and a finger that are connected to each other, and the electrode is a higher one of the busbar and the finger;
or the back surface is provided with a finger, and the electrode is the finger.

7. The solar cell according to any of claims 1 to 6, wherein the plurality of isolation members on the light receiving surface are axially symmetrically arranged;
and/or
the light receiving surface is provided with a plurality of regions, isolation members is provided in each region, and extension directions of isolation members in two adjacent regions are staggered.

8. The solar cell according to any of claims 1 to 7, wherein:
a plurality of electrodes sequentially arranged at intervals along a third direction are provided on the back surface; and
the isolation member comprises a first protective member, at least one of the light receiving surface and the back surface is provided with a plurality of first protective members that are arranged at intervals, a maximum dimension of an orthographic projection of each of the plurality of first protective members on the back surface along the third direction is greater than a distance between two adjacent electrodes.

9. The solar cell according to any of claims 1 to 8, wherein
the isolation member is a protective adhesive unit;
a protective adhesive layer is provided on at least one of the back surface and the light receiving surface of the solar cell, the back surface is provided with a plurality of electrodes, the protective adhesive layer comprising a plurality of protective adhesive units provided at intervals; and
a minimum distance between two adjacent protective adhesive units is less than a projection width of the electrode on the surface of the solar cell,
wherein, preferably,
the electrode comprises a terminal line, a welding point, and a finger, the terminal line is electrically connected to a part of the finger, and the minimum distance between the two adjacent protective adhesive units is less than a projection width of a highest one of the terminal line, the welding point, and the finger on the back surface of the solar cell;
or, preferably,
the electrode comprises a welding point, a busbar, and a finger, and the minimum distance between the two adjacent protective adhesive units is less than a projection width of a highest one of the welding point, the busbar, and the finger on the back surface of the solar cell;
or, preferably,
the electrode comprises a welding point and a finger, and the minimum distance between the two adjacent protective adhesive units is less than a projection width of a higher one of the welding point and the finger on the back surface of the solar cell.

10. The solar cell according to any of claims 1 to 9, wherein:
the solar cell is a back contact solar cell;
the electrode comprises a plurality of support grid lines provided on the back surface of the solar cell body;
the isolation member comprises a plurality of isolation protrusions provided on the light receiving surface of the solar cell body and protruding from the light receiving surface of the solar cell body, and an arrangement direction of the plurality of isolation protrusions is parallel to an extension direction of the support grid line; and
at least part of the plurality of support grid lines overlaps with projections of the plurality of isolation protrusions on the back surface of the solar cell body.

11. The solar cell according to any of claims 1 to 10, wherein:
the back surface is a first surface, and the light receiving surface is a second surface;
the electrode comprises a plurality of fingers provided on the first surface of the solar cell body;
a plurality of isolation members are provided on the first surface and/or the second surface of the solar cell body, an extension direction of the plurality of isolation members is intersected with an extension direction of the plurality of fingers; and
the plurality of isolation members comprise a plurality of isolation bumps arranged along the extension direction of the isolation member, a distance between two adjacent isolation bumps of a same isolation member in the extension direction of the isolation member is greater than a distance between two adjacent fingers,
wherein, preferably, the plurality of fingers comprise first fingers and second fingers that are alternately arranged along a direction perpendicular to the plurality of fingers; and
the distance between the two adjacent isolation bumps of the same isolation member in the extension direction of the isolation member is preferably greater than a distance between two adjacent first fingers;
and/or the distance between the two adjacent isolation bumps of the same isolation member in the extension direction of the isolation member is preferably greater than a distance between two adjacent second fingers.

12. The solar cell according to any of claims 1 to 11, wherein:
one of the light receiving surface and the back surface is a first surface, and the other is a second surface; and
the isolation member comprises a plurality of isolation bumps provided on at least one of the first surface and the second surface of the solar cell body, the plurality of isolation bumps is arranged in a plurality of rows along a first direction, each of the plurality of rows of isolation bumps comprise a plurality of isolation bumps arranged along a second direction,
wherein *l* is a larger one of a distance between two adjacent isolation bumps along the first direction and a distance between two adjacent isolation bumps along the second direction, h is a height of each of the plurality of isolation bumps, and n is an integer obtained by rounding off a ratio of a long side to a short side of the solar cell, and *l*, h, and n satisfy a relation: $0 < l < \sqrt[4]{15.3 ∗ {10}^{5} {mm}^{3} ∗ hn} .$

13. The solar cell according to any of claims 1 to 12, wherein the back surface is a first surface, and the light receiving surface is a second surface;
the electrode comprises a plurality of fingers provided on the first surface of the solar cell body; and
the isolation member comprises a plurality of isolation structures provided on at least one of the first surface and the second surface of the solar cell body, and the plurality of isolation structures are arranged along a direction perpendicular to the finger,
wherein a distance between two adjacent fingers is greater than a distance between two adjacent isolation structures along the direction perpendicular to the finger.

14. The solar cell according to any of claims 1 to 13, wherein an orthographic projection of the isolation member on the back surface at least partially overlaps with the electrode;
and/or a coverage ratio of the isolation member on at least one of the light receiving surface and the back surface is S81, wherein 0.5% ≤ S81 ≤ 10%;
and/or
a height of the isolation member in a direction facing away from the solar cell body ranges from 2 µm to 80 µm;
and/or
the maximum dimension of the isolation bump (621) is D, where 50 µm ≤ D ≤ 2000 µm;
and/or
the material of the isolation member includes a light-curing adhesive material.

15. A photovoltaic module, comprising the solar cell according to any one of claims 1 to 14.
